# EUROPEAN PATENT APPLICATION

(11) **EP 3 985 728 A1**
(43) Date of publication of application: **20.04.2022**
(21) Application number: 19947867.8
(22) Date of filing: 30.09.2019
(51) Int. Cl.: H01L 27/146, H01L 27/148, H04N 5/225, H04N 5/235, H04N 5/369, H04N 9/04

(54) **IMAGE SENSOR, CAMERA ASSEMBLY, AND MOBILE TERMINAL**

(71) Applicant: GUANGDONG OPPO MOBILE TELECOMMUNICATIONS CORP., LTD., Dongguan, Guangdong 523860 (CN)
(72) Inventor: TANG, Cheng, Dongguan, Guangdong 523860 (CN); ZHANG, Gong, Dongguan, Guangdong 523860 (CN); ZHANG, Haiyu, Dongguan, Guangdong 523860 (CN); XU, Rui, Dongguan, Guangdong 523860 (CN); YANG, Xin, Dongguan, Guangdong 523860 (CN); LAN, He, Dongguan, Guangdong 523860 (CN); SUN, Jianbo, Dongguan, Guangdong 523860 (CN); LI, Xiaotao, Dongguan, Guangdong 523860 (CN); WANG, Wentao, Dongguan, Guangdong 523860 (CN)
(74) Representative: Thorniley, Peter
(86) International application number: PCT/CN2019/109517
(87) International publication number: WO 2021/062662

(57) **Abstract**

An image sensor (10), a camera assembly (40), and a mobile terminal (90) are provided. The image sensor (10) includes a plurality of pixels. At least some of the plurality of pixels each include an isolation layer (1183), a condenser lens (1186), and a photoelectric conversion element (117). The condenser lens (1186) is provided within the isolation layer (1183). The photoelectric conversion element (117) is configured to receive light passing through the condenser lens (1186).

## Description

### TECHNICAL FIELD

The present disclosure relates to the field of image technologies, and more particularly, to an image sensor, a camera assembly, and a mobile terminal.

### BACKGROUND

Electronic devices such as mobile phones are typically equipped with cameras to provide photographing functions. An image sensor is provided in a camera. In order to capture color images, the image sensor is typically provided with a plurality of pixels arranged in a two-dimensional array. When the image sensor is operating, there may be a problem of optical cross interference between adjacent pixels.

### SUMMARY

The present disclosure provides an image sensor, a camera assembly, and a mobile terminal.

In one aspect of the present disclosure, an image sensor is provided. The image sensor includes a plurality of pixels. At least some of the pixels each include an isolation layer, a condenser lens, and a photoelectric conversion element. The condenser lens is provided within the isolation layer. The photoelectric conversion element is configured to receive light passing through the condenser lens.

In another aspect of the present disclosure, a camera assembly is provided. The camera assembly includes an image sensor. The image sensor includes a plurality of pixels. At least some of the pixels each include an isolation layer, a condenser lens, and a photoelectric conversion element. The condenser lens is provided within the isolation layer. The photoelectric conversion element is configured to receive light passing through the condenser lens.

In yet another aspect of the present disclosure, a mobile terminal is provided. The mobile terminal includes a housing and an image sensor mounted within the housing. The image sensor includes a plurality of pixels. At least some of the pixels each include an isolation layer, a condenser lens, and a photoelectric conversion element. The condenser lens is provided within the isolation layer. The photoelectric conversion element is configured to receive light passing through the condenser lens.

Additional aspects and advantages of the embodiments of the present disclosure will be given in part in the following description, or become apparent in part from the following description, or can be learned from practice of the present disclosure.

### BRIEF DESCRIPTION OF DRAWINGS

The above and/or additional aspects and advantages of the present disclosure will become more apparent and more understandable from the following description of embodiments taken in conjunction with the accompanying drawings, in which:
FIG. 1 is a schematic diagram showing an image sensor in an embodiment of the present disclosure;
FIG. 2 is a schematic diagram showing a pixel circuit in an embodiment of the present disclosure;
FIG. 3 is a schematic diagram showing exposure saturation time for different color channels;
FIG. 4A is a schematic diagram showing a partial cross-sectional view of a pixel array in an embodiment of the present disclosure;
FIG. 4B is a schematic diagram showing an arrangement of photoelectric conversion elements (or filters) in the pixel array of FIG. 4A;
FIG. 5A is a schematic diagram showing a partial cross-sectional view of another pixel array in an embodiment of the present disclosure;
FIG. 5B is a schematic diagram showing an arrangement of photoelectric conversion elements (or filters) in the pixel array of FIG. 5A;
FIG. 5C is a schematic diagram showing another arrangement of photoelectric conversion elements (or filters) in the pixel array of FIG. 5A;
FIG. 6A is a schematic diagram showing a partial cross-sectional view of another pixel array in an embodiment of the present disclosure;
FIG. 6B is a schematic diagram showing an arrangement of filters in the pixel array of FIG. 6A;
FIG. 6C is a schematic diagram showing an arrangement of photoelectric conversion elements in the pixel array of FIG. 6A;
FIG. 7A is a schematic diagram showing a partial cross-sectional view of another pixel array in an embodiment of the present disclosure;
FIG. 7B is a schematic diagram showing an arrangement of filters in the pixel array of FIG. 7A;
FIG. 7C is a schematic diagram showing an arrangement of photoelectric conversion elements in the pixel array of FIG. 7A;
FIG. 8A is a schematic diagram showing a partial cross-sectional view of another pixel array in an embodiment of the present disclosure;
FIG. 8B is a schematic diagram showing an arrangement of filters in the pixel array of FIG. 8A;
FIG. 8C is a schematic diagram showing an arrangement of photoelectric conversion elements in the pixel array of FIG. 8A;
FIG. 9 is a schematic diagram showing a partial cross-sectional view of another pixel array in an embodiment of the present disclosure;
FIG. 10A is a schematic diagram showing a partial cross-sectional view of another pixel array in an embodiment of the present disclosure;
FIG. 10B is a schematic diagram showing an arrangement of photoelectric conversion elements (or filters) in the pixel array of FIG. 10A;
FIG. 11A is a schematic diagram showing a partial cross-sectional view of another pixel array in an embodiment of the present disclosure;
FIG. 11B is a schematic diagram showing an arrangement of photoelectric conversion elements (or filters) in the pixel array of FIG. 11A;
FIG. 11C is a schematic diagram showing another arrangement of photoelectric conversion elements (or filters) in the pixel array of FIG. 11A;
FIG. 12A is a schematic diagram showing a partial cross-sectional view of another pixel array in an embodiment of the present disclosure;
FIG. 12B is a schematic diagram showing an arrangement of filters in the pixel array of FIG. 12A;
FIG. 12C is a schematic diagram showing an arrangement of photoelectric conversion elements in the pixel array of FIG. 12A;
FIG. 13A is a schematic diagram showing a partial cross-sectional view of another pixel array in an embodiment of the present disclosure;
FIG. 13B is a schematic diagram showing an arrangement of filters in the pixel array of FIG. 13 A;
FIG. 13C is a schematic diagram showing an arrangement of photoelectric conversion elements in the pixel array of FIG. 13A;
FIG. 14A is a schematic diagram showing a partial cross-sectional view of another pixel array in an embodiment of the present disclosure;
FIG. 14B is a schematic diagram showing an arrangement of filters in the pixel array of FIG. 14A;
FIG. 14C is a schematic diagram showing an arrangement of photoelectric conversion elements in the pixel array of FIG. 14A;
FIG. 15A is a schematic diagram showing a partial cross-sectional view of another pixel array in an embodiment of the present disclosure;
FIG. 15B is a schematic diagram showing a partial cross-sectional view of another pixel array in an embodiment of the present disclosure;
FIG. 16 is a schematic diagram showing a pixel array and a connection scheme of exposure control lines in an embodiment of the present disclosure;
FIG. 17 is a schematic diagram showing a pixel arrangement for a minimum repeated unit in an embodiment of the present disclosure;
FIG. 18 is a schematic diagram showing another pixel arrangement for a minimum repeated unit in an embodiment of the present disclosure;
FIG. 19 is a schematic diagram showing another pixel arrangement for a minimum repeated unit in an embodiment of the present disclosure;
FIG. 20 is a schematic diagram showing another pixel arrangement for a minimum repeated unit in an embodiment of the present disclosure;
FIG. 21 is a schematic diagram showing another pixel arrangement for a minimum repeated unit in an embodiment of the present disclosure;
FIG. 22 is a schematic diagram showing another pixel arrangement for a minimum repeated unit in an embodiment of the present disclosure;
FIG. 23 is a schematic diagram showing another pixel arrangement for a minimum repeated unit in an embodiment of the present disclosure;
FIG. 24 is a schematic diagram showing another pixel arrangement for a minimum repeated unit in an embodiment of the present disclosure;
FIG. 25 is a schematic diagram showing another pixel arrangement for a minimum repeated unit in an embodiment of the present disclosure;
FIG. 26 is a schematic diagram showing another pixel arrangement for a minimum repeated unit in an embodiment of the present disclosure;
FIG. 27 is a schematic diagram showing another pixel arrangement for a minimum repeated unit in an embodiment of the present disclosure;
FIG. 28 is a schematic diagram showing another pixel arrangement for a minimum repeated unit in an embodiment of the present disclosure;
FIG. 29 is a schematic diagram showing another pixel arrangement for a minimum repeated unit in an embodiment of the present disclosure;
FIG. 30 is a schematic diagram showing another pixel arrangement for a minimum repeated unit in an embodiment of the present disclosure;
FIG. 31 is a schematic diagram showing another pixel arrangement for a minimum repeated unit in an embodiment of the present disclosure;
FIG. 32 is a schematic diagram showing another pixel arrangement for a minimum repeated unit in an embodiment of the present disclosure;
FIG. 33 is a schematic diagram showing a camera assembly according to an embodiment of the present disclosure;
FIG. 34 is a flowchart illustrating an image capturing method according to some embodiments of the present disclosure;
FIG. 35 is a schematic diagram showing a principle of an image capturing method in the related art;
FIG. 36 is a schematic diagram showing a principle of an optical image capturing method in an embodiment of the present disclosure;
FIG. 37 is another schematic diagram showing a principle of an optical image capturing method in an embodiment of the present disclosure;
FIG. 38 to 41 are flowcharts illustrating image capturing methods in some embodiments of the present disclosure;
FIG. 42 is another schematic diagram showing a principle of an optical image capturing method in an embodiment of the present disclosure;
FIG. 43 is another schematic diagram showing a principle of an optical image capturing method in an embodiment of the present disclosure;
FIG. 44 is another schematic diagram showing a principle of an optical image capturing method in an embodiment of the present disclosure;
FIG. 45 is another schematic diagram showing a principle of an optical image capturing method in an embodiment of the present disclosure;
FIG. 46 is another schematic diagram showing a principle of an optical image capturing method in an embodiment of the present disclosure; and
FIG. 47 is a schematic diagram showing a mobile terminal according to an embodiment of the present disclosure.

### DESCRIPTION OF EMBODIMENTS

The embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

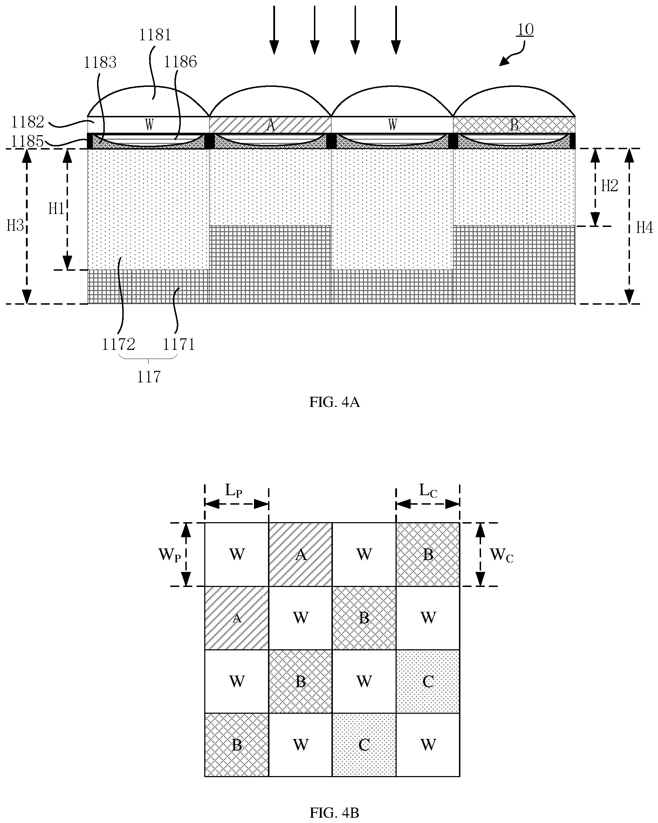

Referring to FIG. 4A, the present disclosure provides an image sensor 10 including a plurality of pixels. At least some of the pixels each include an isolation layer 1183, a condenser lens 1186, and a photoelectric conversion element 117. The condenser lens 1186 is disposed in the isolation layer 1183. The photoelectric conversion element 117 is configured to receive light passing through the condenser lens 1186.

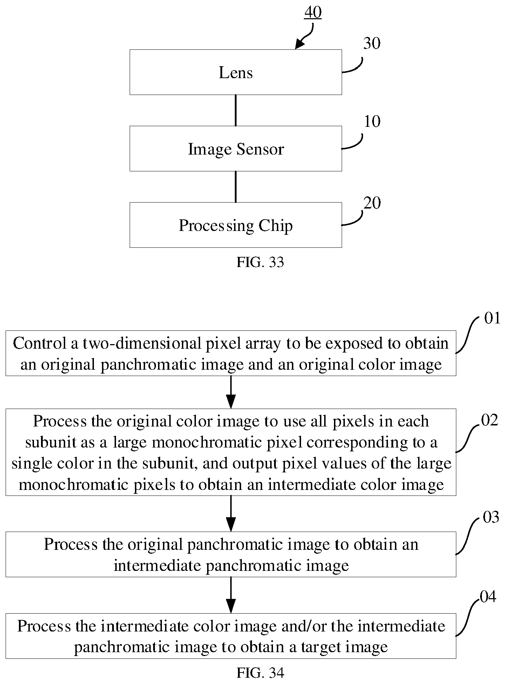

Referring to FIG. 4A and FIG. 33, the present disclosure also provides a camera assembly 40. The camera assembly 40 includes the image sensor 10. The image sensor 10 includes a plurality of pixels. At least some of the pixels each include an isolation layer 1183, a condenser lens 1186, and a photoelectric conversion element 117. The condenser lens 1186 is disposed in the isolation layer 1183. The photoelectric conversion element 117 is configured to receive light passing through the condenser lens 1186.

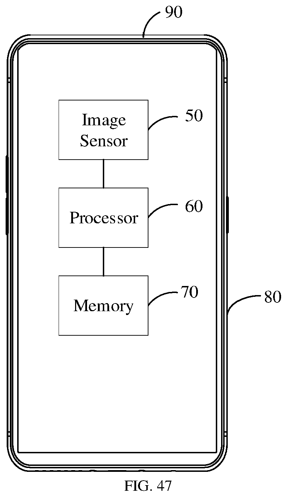

Referring to FIG. 4A and FIG. 47, the present disclosure also provides a mobile terminal 90. The mobile terminal includes an image sensor 50 and a housing 80. The image sensor 50 is mounted on the housing 80. The image sensor 10 includes a plurality of pixels. At least some of the pixels each include an isolation layer 1183, a condenser lens 1186, and a photoelectric conversion element 117. The condenser lens 1186 is disposed in the isolation layer 1183. The photoelectric conversion element 117 is configured to receive light passing through the condenser lens 1186. The embodiments of the present disclosure will be further described below in conjunction with the drawings.

In an image sensor including a plurality of pixels arranged in a plurality of two-dimensional pixel arrays, when non-perpendicularly irradiated light passes through a microlens and a filter of a certain pixel, a part of the light may be incident on a photoelectric conversion element in an adjacent pixel, which causes optical cross interference. For an image sensor that contains pixels of multiple colors, such optical cross interference between adjacent pixels will cause a color mixing problem, which in turn degrades image quality.

Based on the above reasons, as shown in FIG. 4A, the present disclosure provides an image sensor 10. By additionally providing in each pixel an isolation layer 1183 and a condenser lens 1186 provided within the isolation layer 1183, the light passing through the microlens 1181 and the filter 1182 of each pixel can be condensed by the condenser lens 1186, and then be incident on the photoelectric conversion element 117 of the pixel to avoid the problem of optical cross interference between adjacent pixels.

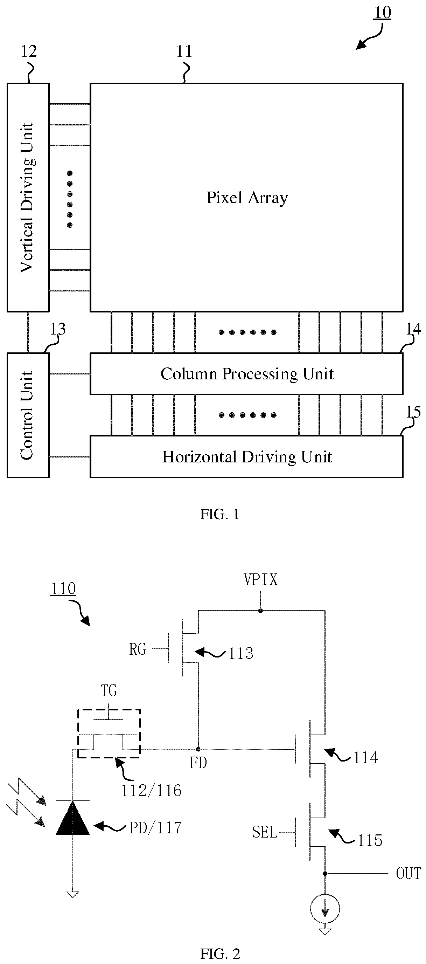

Next, the basic structure of the image sensor 10 will be introduced first. Referring to FIG. 1, which is a schematic diagram showing an image sensor 10 in an embodiment of the present disclosure, the image sensor 10 includes a pixel array 11, a vertical driving unit 12, a control unit 13, a column processing unit 14, and a horizontal driving unit 15.

For example, the image sensor 10 may use a Complementary Metal Oxide Semiconductor (CMOS) photosensitive element or a Charge-Coupled Device (CCD) photosensitive element.

For example, the pixel array 11 includes a plurality of pixels (not shown in FIG. 1) arranged in a two-dimensional array, and each pixel includes a photoelectric conversion element 117 (shown in FIG. 2). Each pixel converts light into electric charges according to the intensity of light incident thereon.

For example, the vertical driving unit 12 includes a shift register and an address decoder. The vertical driving unit 12 includes functions of readout scanning and reset scanning. The readout scanning refers to sequentially scanning unit pixels row by row, and reading signals from these unit pixels row by row. For example, the signal outputted by each pixel in the pixel row that is selected and scanned is transmitted to the column processing unit 14. The reset scanning is used to reset charges, and photo-charges of the photoelectric conversion element 117 can be discarded, such that new accumulation of photo-charges can be started.

For example, the signal processing performed by the column processing unit 14 is a Correlated Double Sampling (CDS) processing. In the CDS processing, a reset level and a signal level outputted from each pixel in a selected pixel row are taken, and a level difference is calculated. Thus, the signals of the pixels in the row are obtained. The column processing unit 14 may have an Analog-to-Digital (A/D) conversion function for converting analog pixel signals into a digital format.

For example, the horizontal driving unit 15 includes a shift register and an address decoder. The horizontal driving unit 15 sequentially scans the pixel array 11 column by column. With the selection and scanning operations performed by the horizontal driving unit 15, each pixel column is sequentially processed by the column processing unit 14 and is sequentially outputted.

For example, the control unit 13 configures timing signals in accordance with an operation mode, and utilizes the timing signals to control the vertical driving unit 13, the column processing unit 14, and the horizontal driving unit 15 to cooperate.

FIG. 2 is a schematic diagram showing a pixel circuit 110 in an embodiment of the present disclosure. The pixel circuit 110 in FIG. 2 is applied in each pixel in FIG. 1. The operation principle of the pixel circuit 110 will be described below in conjunction with FIG. 1 and FIG. 2.

As shown in FIG. 2, the pixel circuit 110 includes a photoelectric conversion element 117 (for example, a photodiode or PD), an exposure control circuit 116 (for example, a transfer transistor 112), a reset circuit (for example, a reset transistor 113), an amplifier circuit (for example, an amplifying transistor 114), and a selection circuit (for example, a selection transistor 115). In an embodiment of the present disclosure, the transfer transistor 112, the reset transistor 113, the amplifying transistor 114, and the selection transistor 115 may be MOS transistors, as a non-limiting example.

For example, referring to FIGS. 1 and 2, the gate TG of the transfer transistor 112 is connected to the vertical driving unit 12 through an exposure control line (not shown in the figures), the gate RG of the reset transistor 113 is connected to the vertical driving unit 12 through a reset control line (not shown in the figures), and the gate SEL of the selection transistor 114 is connected to the vertical driving unit 12 through a selection line (not shown in the figures). The exposure control circuit 116 (for example, the transfer transistor 112) in each pixel circuit 110 is electrically connected to the photoelectric conversion element 117 for transferring the electric potential accumulated at the photoelectric conversion element 117 after being irradiated. For example, the photoelectric conversion element 117 may include a photodiode PD, and the anode of the photodiode PD is connected to e.g., the ground. The photodiode PD converts the received light into electric charges. The cathode of the photodiode PD is connected to a floating diffusion unit FD via the exposure control circuit 116 (for example, the transfer transistor 112). The floating diffusion unit FD is connected to the gate of the amplifying transistor 114 and the source of the reset transistor 113.

For example, the exposure control circuit 116 may be the transfer transistor 112, and the control terminal TG of the exposure control circuit 116 may be the gate of the transfer transistor 112. When a pulse at an effective level (for example, a VPIX level) is transmitted to the gate of the transfer transistor 112 through an exposure control line (not shown in the figures), the transfer transistor 112 is turned on. The transfer transistor 112 transfers the charges photoelectrically converted by the photodiode PD to the floating diffusion unit FD.

For example, the drain of the reset transistor 113 may be connected to a pixel power supply VPIX. The source of the reset transistor 113 may be connected to the floating diffusion unit FD. Before the charges are transferred from the photodiode PD to the floating diffusion unit FD, a pulse at an effective reset level may be transmitted to the gate of the reset transistor 113 via a reset line, and the reset transistor 113 is turned on. The reset transistor 113 resets the floating diffusion unit FD to the pixel power supply VPIX.

For example, the gate of the amplifying transistor 114 may be connected to the floating diffusion unit FD. The drain of the amplifying transistor 114 may be connected to the pixel power supply VPIX. After the floating diffusion unit FD is reset by the reset transistor 113, the amplifying transistor 114 outputs a reset level through the output terminal OUT via the selection transistor 115. After the charges from the photodiode PD are transferred by the transfer transistor 112, the amplifying transistor 114 outputs a signal level through the output terminal OUT via the selection transistor 115.

For example, the drain of the selection transistor 115 may be connected to the source of the amplifying transistor 114. The source of the selection transistor 115 may be connected to the column processing unit 14 in FIG. 1 through the output terminal OUT. When a pulse at the effective level is transmitted to the gate of the selection transistor 115 through the selection line, the selection transistor 115 is turned on. A signal outputted by the amplifying transistor 114 is transmitted to the column processing unit 14 through the selection transistor 115.

It is to be noted that the pixel structure of the pixel circuit 110 in the embodiment of the present disclosure is not limited to the structure shown in FIG. 2. For example, the pixel circuit 110 may have a three-transistor pixel structure, in which the functions of the amplifying transistor 114 and the selecting transistor 115 are performed by one transistor. For example, the exposure control circuit 116 is not limited to one single transfer transistor 112, and any other electronic device or structure having a control terminal controlling a function of conduction can be used as the exposure control circuit in the embodiment of the present disclosure. The implementation of one single transfer transistor 112 is simple, inexpensive, and easy to control.

The condenser lens 1186 may be applied in an image sensor that only includes color pixels (including but not limited to RGB), or may be applied in an image sensor that includes panchromatic pixels and color pixels, for improving imaging quality of the image sensor. However, in addition to optical cross interference that could degrade the imaging quality of the image sensor, the sensitivity of pixels (that is, the exposure amount received per unit time) may also affect the imaging quality of the image sensor. For example, in an image sensor including panchromatic pixels and color pixels, pixels of different colors receive different exposure amounts per unit time. After some colors are saturated, some other colors have not yet been exposed to an ideal state. For example, a pixel with an exposure to 60%-90% of the saturated exposure amount may have a relatively good signal-to-noise ratio and accuracy, but the embodiment of the present disclosure is not limited to this.

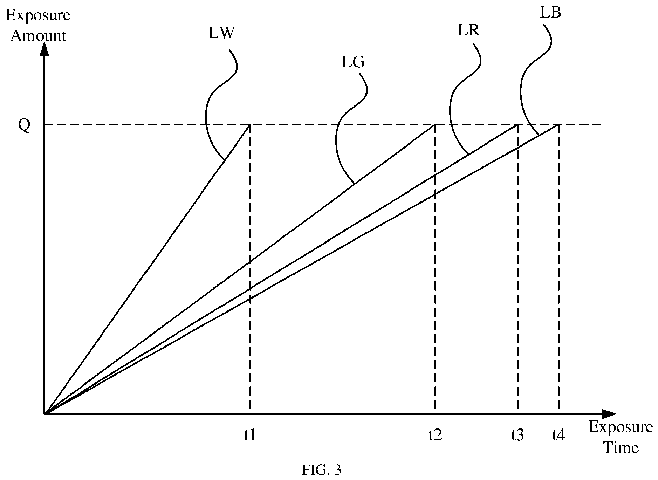

In FIG. 3, four pixels of RGBW (red, green, blue, and panchromatic) are taken as an example. Referring to FIG. 3, in FIG 3, the horizontal axis is the exposure time, the vertical axis is the exposure amount, Q is the saturated exposure amount, LW is the exposure curve of the panchromatic pixel W, LG is the exposure curve of the green pixel G, and LR is the exposure curve of the red pixel R, and LB is the exposure curve of the blue pixel.

It can be seen from FIG. 3 that the exposure curve LW of the panchromatic pixel W has the largest slope, which means the panchromatic pixel W can obtain more exposure per unit time, and become saturated at time t1. The exposure curve LG of the green pixel G has the second largest slope, and the green pixel is saturated at time t2. The exposure curve LR of the red pixel R has the third largest slope, and the red pixel is saturated at time t3. The exposure curve LB of the blue pixel B has the smallest slope, and the blue pixel is saturated at time t4. At time t1, the panchromatic pixel W has been saturated, and the exposure of each of the three pixels R, G, and B has not yet reached the ideal state.

In the related art, the exposure time of the four RGBW pixels is controlled jointly. For example, pixels in each row have the same exposure time and are connected to the same exposure control line and controlled by the same exposure control signal. For example, referring to FIG. 3 again, during the time period 0 to t1, all the four RGBW pixels can operate normally. However, due to the short exposure time and small exposure amount of RGB during this time period, the image will be displayed with low brightness, a low signal-to-noise ratio, and even colors that are not vivid enough. In the time period t1 to t4, the W pixel is overexposed due to having been saturated and cannot operate, and data of the exposure amount can no longer truly reflect the subject.

In order to allow the image sensor 10 to have better imaging quality, in addition to solving the problem of optical cross interference by adding the condenser lens 1186, it is also possible to further increase the full well capacity of the panchromatic pixel, such that the full well capacity of the panchromatic pixel can be greater than that of the color pixel, so as to avoid the problem of premature saturation of panchromatic pixels, thereby improving the quality of the captured image.

It is to be noted that the exposure curves in FIG. 3 are exemplary only, and the slopes of the curves and the relative relations between the curves will vary depending on different response bands of the pixels. The present disclosure is not limited to the case shown in FIG. 3. For example, when the response band of the red pixel R is relatively narrow, the slope of the exposure curve of the red pixel R may be smaller than the slope of the exposure curve of the blue pixel B.

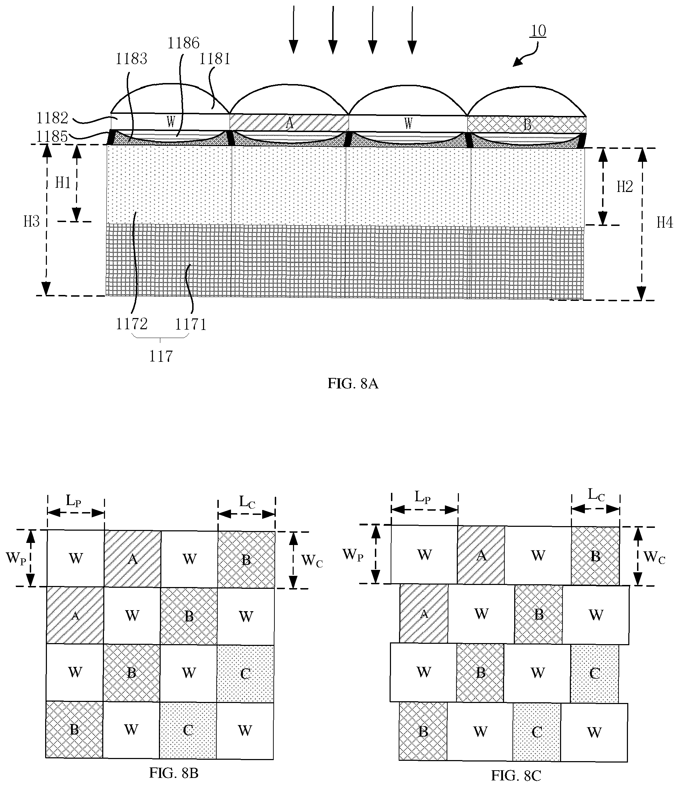

FIGS. 4A to 8C are schematic diagrams showing various cross-sectional views of some pixels in the pixel array 11 of FIG. 1, taken along a light-receiving direction of the image sensor 10, and arrangements of the photoelectric conversion elements 117 (or filters 1182) of the pixel array 11. Here, the panchromatic pixels and the color pixels are arranged alternately. Each color pixel has a narrower spectral response than each panchromatic pixel. Each panchromatic pixel and each color pixel includes a micro lens 1181, a filter 1182, a condenser lens 1186, and a photoelectric conversion element 117. The microlens 1181, the filter 1182, the isolation layer 1183, and the photoelectric conversion element 117 are sequentially arranged in the light-receiving direction of the image sensor 10. The photoelectric conversion element 117 can convert received light into electric charges. Specifically, the photoelectric conversion element 117 includes a substrate 1171 and an n-potential well layer 1172 formed within the substrate 1171. The n-potential well layer 1172 can provide light-to-charge conversion. The isolation layer 1183 is provided on a surface of the photoelectric conversion element 117 (specifically, a surface of the substrate 1171). Since the substrate 1171 is not completely flat, it is difficult for the filter 1182 to be directly provided on the surface of the substrate 1171. The isolation layer 1183 is arranged on one surface of the substrate 1171, and the surface of the isolation layer 1183 that is away from the substrate 1171 has a relatively high flatness, which facilitates the arrangement of the filter 1182 on this surface. The filter 1182 is arranged on the surface of the isolation layer 1183 that is away from the substrate 1171, and the filter 1182 can allow light of a specific band to pass. The microlens 1181 is arranged on the side of the filter 1182 that is away from the isolation layer 1183. The microlens 1181 is configured to condense light and can guide the incident light to the photoelectric conversion element 117. The condenser lens 1186 is provided in the isolation layer 1183. The condenser lens 1186 can be configured to condense the light passing through the microlens 1181 and the filter 1182, such that more light can enter the corresponding photoelectric conversion element 117 to avoid the problem of optical cross interference between adjacent pixels. A full well capacity of the photoelectric conversion element 117 depends on a volume of the n-potential well layer of the photoelectric conversion element 117. The greater the volume of the n-potential well layer 1172 is, the greater the full well capacity will be. In any of the embodiments shown in FIGS. 4A to 8C, a volume of a n-potential well layer 1172 of the panchromatic pixel is greater than a volume of a n-potential well layer 1172 of the color pixel, such that the full well capacity of the panchromatic pixel is greater than the full well capacity of the color pixel. This increases the exposure amount Q of the panchromatic pixel when it is saturated, and increases the time length for the panchromatic pixel to become saturated, thereby avoiding the problem of premature saturation of the panchromatic pixel, and balancing the exposure of the panchromatic pixel and the color pixel. In this way, the imaging quality of the image sensor 10 can be improved by the design of the condenser lens 1186 and the design that the full well capacity of the panchromatic pixel is greater than the full well capacity of the color pixel.

For example, FIGS. 4A and 4B are schematic diagrams showing a cross-sectional view of the pixel array 11 taken along the light-receiving direction and a schematic view of an arrangement of a plurality of photoelectric conversion elements 117 (or filters 1182) in an embodiment of the present disclosure, respectively. As shown in FIG. 4A, in the light-receiving direction, the sizes of a plurality of cross-sections of the isolation layer 1183 of each pixel (the same pixel) are equal. The condenser lens 1186 is arranged within the isolation layer 1183. In the light-receiving direction, the sizes of the plurality of cross-sections of the n-potential well layer 1172 of each pixel (the same pixel) are equal. The size of the cross section of the n-potential well layer 1172 of the panchromatic pixel is equal to that of the n-potential well layer 1172 of the color pixel. The depth H1 of the n-potential well layer 1172 of the panchromatic pixel is greater than the depth H2 of the n-potential well layer 1172 of the color pixel. In this way, the volume of the n-potential well layer 1172 of the panchromatic pixel is greater than the volume of the n-potential well layer 1172 of the color pixel, and the panchromatic pixel has a greater full well capacity than the color pixel. In addition, in the image sensor 10 shown in FIG. 4A, the condenser lens 1186 condenses light such that more light can enter the corresponding photoelectric conversion element 117, thereby avoiding the problem of optical cross interference.

It is to be noted that the cross section of the isolation layer 1183 is a cross section of the isolation layer taken along the direction perpendicular to the light-receiving direction, and the cross section of the n-potential well layer 1172 is a cross section of n-potential well layer 1172 taken along the direction perpendicular to the light-receiving direction. The cross section of the isolation layer 1183 of each pixel corresponds to the shape and size of the cross section of the n-potential well layer 1172 of the pixel. The cross section can be any polygon such as rectangle, square, parallelogram, rhombus, pentagon, hexagon, etc., and the present disclosure is not limited to any of these examples.

In the light-receiving direction, the sizes of a plurality of cross-sections of the n-potential well layer 1172 (or the isolation layer 1183) of the same pixel being all equal means that the a plurality of cross-sections have the same area, and the corresponding side lengths of the plurality of cross-sections are equal. The size of the cross section of the n-potential well layer 1172 of the panchromatic pixel being equal to the size of the cross section of the n-potential well layer 1172 of the color pixel means that the area of the cross section of the n-potential well layer 1172 of the panchromatic pixel is equal to the area of the cross section of the n-potential well layer 1172 of the color pixel. The side lengths of the shape formed by the cross section of the n-potential well layer 1172 of the panchromatic pixel and the corresponding side lengths of the shape formed by the cross section of the n-potential well layer 1172 of the color pixel may be equal or unequal. For example, the cross sections of the n-potential well layers 1172 of the panchromatic pixel and the color pixel shown in FIG. 4B are both rectangles, each having a length and a width. The area of the cross section of the n-potential well layer 1172 of the panchromatic pixel is equal to the area of the cross section of the n-potential well layer 1172 of the color pixel, the length L_{P} of the cross section of the n-potential well layer 1172 of the panchromatic pixel is equal to the length Lc of the cross section of the n-potential well layer 1172 of the color pixel, and the width W_{P} of the cross section of the n-potential well layer 1172 of the panchromatic pixel is equal to the width Wc of the cross section of the n-potential well layer 1172 of the color pixel. In other examples, L_{P} may not be equal to Lc, and W_{P} may not be equal to Wc, as long as the area of the cross section of the n-potential well layer 1172 of the panchromatic pixel is equal to the area of the cross section of the n-potential well layer 1172 of the color pixel. Such interpretations of the cross-section of the n-potential well layer 1172 (or isolation layer 1183), the sizes of the plurality of cross-sections of the n-potential well layer 1172 (or isolation layer 1183) of each pixel being equal, and the size of the cross section of the n-potential well layer 1172 of the panchromatic pixel being equal to the size of the cross section of the n-potential well layer 1172 of the color pixel also apply to the description below.

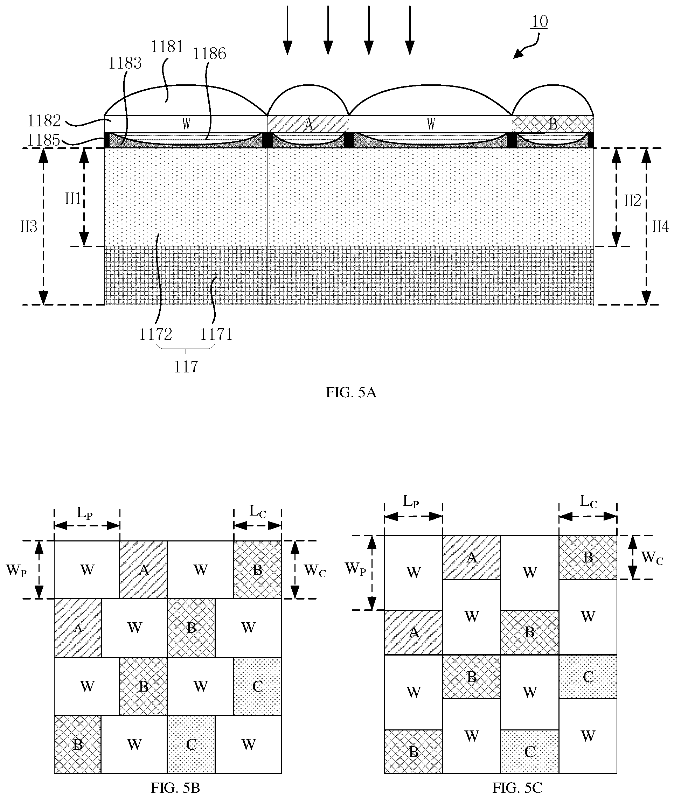

For example, FIG. 5A is a schematic diagram showing a cross-sectional view taken along the light-receiving direction of the pixel array 11 according to another embodiment of the present disclosure, and FIG. 5B and FIG. 5C are schematic diagrams showing arrangements of a plurality of photoelectric conversion elements 117 (or filters 1182) in the pixel array 11. As shown in FIG. 5A, in the light-receiving direction, the sizes of the plurality of cross-sections of the isolation layer 1183 of each pixel (the same pixel) are all equal. The condenser lens 1186 is arranged within the isolation layer 1183. In the light-receiving direction, the sizes of the plurality of cross-sections of the n-potential well layer 1172 of each pixel (the same pixel) are equal. The size of the cross section of the n-potential well layer 1172 of the panchromatic pixel is greater than the size of the cross section of the n-potential well layer 1172 of the color pixel. The depth H1 of the n-potential well layer 1172 of the panchromatic pixel is equal to the depth H2 of the n-potential well layer 1172 of the color pixel. In this way, the volume of the n-potential well layer 1172 of the panchromatic pixel is greater than the volume of the n-potential well layer 1172 of the color pixel, and the panchromatic pixel has a greater full well capacity than the color pixel. In addition, in the image sensor 10 shown in FIG. 5A, the condenser lens 1186 condenses light such that more light enters the corresponding photoelectric conversion element 117, thereby avoiding the problem of optical cross interference.

Of course, in other embodiments, the depth H1 of the n-potential well layer 1172 of the panchromatic pixel in FIG. 5A may be greater than the depth H2 of the n-potential well layer 1172 of the color pixel.

It is to be noted that the size of the cross section of the n-potential well layer 1172 of the panchromatic pixel being greater than the size of the cross section of the n-potential well layer 1172 of the color pixel means that the area of the cross section of the n-potential well layer 1172 of the panchromatic pixel is greater than the area of the cross section of the n-potential well layer 1172 of the color pixel, and some or all of the side lengths of the shape formed by the cross section of the n-potential well layer of the panchromatic pixel may be greater than the corresponding side lengths of the shape formed by the cross section of the n-potential well layer 1172 of the color pixel. Exemplarily, as shown in FIG. 5B, the length L_{P} of the cross section of the n-potential well layer 1172 of the panchromatic pixel is greater than the length Lc of the cross section of the n-potential well layer 1172 of the color pixel, and the width W_{P} of the cross section of the n-potential well layer 1172 of the panchromatic pixel is equal to the width Wc of the cross section of the n-potential well layer 1172 of the color pixel. As shown in FIG. 5C, the length L_{P} of the cross section of the n-potential well layer 1172 of the panchromatic pixel is equal to the length Lc of the cross section of the n-potential well layer 1172 of the color pixel, and the width W_{P} of the cross section of the n-potential well layer 1172 of the panchromatic pixel is greater than the width Wc of the cross section of the n-potential well layer 1172 of the color pixel. Such explanation of the size of the cross section of the n-potential well layer 1172 of the panchromatic pixel being greater than the size of the cross section of the n-potential well layer 1172 of the color pixel also applies to the description below.

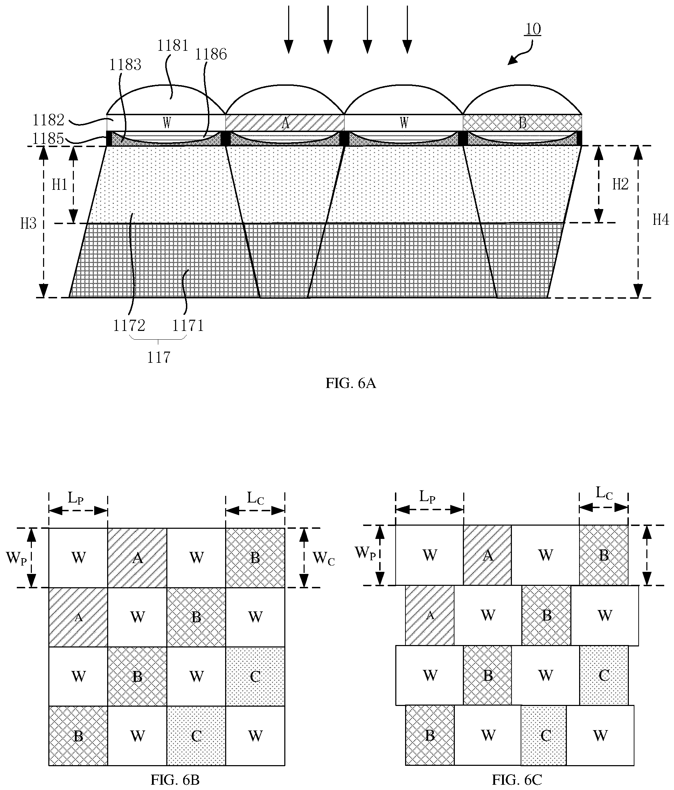

For example, FIGS. 6A to 6C are schematic diagrams showing a cross-sectional view of the pixel array 11 taken along the light-receiving direction, an arrangement of a plurality of filters 1182, and an arrangement of a plurality of photoelectric conversion elements 117 according to another embodiment of the present disclosure, respectively. As shown in FIG. 6A, in the light-receiving direction, the sizes of the cross-sections of the isolation layer 1183 of each pixel (the same pixel) are equal. The condenser lens 1186 is arranged within the isolation layer 1183. In the light-receiving direction, the sizes of the cross sections of the n-potential well layer 1172 of each panchromatic pixel (the same panchromatic pixel) gradually increase, the sizes of the cross sections of the n-potential well layer 1172 of each color pixel (the same color pixel) gradually decreases. The size of the smallest cross section of the n-potential well layer 1172 of the panchromatic pixel is equal to the size of the largest cross section of the n-potential well layer 1172 of the color pixel. The depth H1 of the n-potential well layer 1172 of the panchromatic pixel is equal to the depth H2 of the n-potential well layer 1172 of the color pixel. As shown in FIG. 6B, although the size of the cross section of the filter 1182 of the panchromatic pixel is the same as the size of the cross section of the filter 1182 of the color pixel (the area and the corresponding side lengths are equal), as shown in FIG. 6C, in fact the size of the cross section (the cross section other than the smallest cross section) of the n-potential well layer 1172 in the photoelectric conversion element 117 of the panchromatic pixel is greater than the size of the cross section 1172 of the n-potential well layer in the photoelectric conversion element 117 of the color pixel. In this way, the volume of the n-potential well layer 1172 of the panchromatic pixel is greater than the volume of the n-potential well layer 1172 of the color pixel, and the panchromatic pixel has a greater full well capacity than the color pixel. In addition, in the image sensor 10 shown in FIG. 6A, the condenser lens 1186 condenses light such that more light can enter the corresponding photoelectric conversion element 117, thereby avoiding the problem of optical cross interference.

In other embodiments, the size of the smallest cross section of the n-potential well layer 1172 of the panchromatic pixel in FIG. 6A may be greater than the size of the largest cross section of the n-potential well layer of the color pixel, and the depth H1 of the n-potential well layer 1172 may be greater than the depth H2 of the n-potential well layer 1172 of the color pixel.

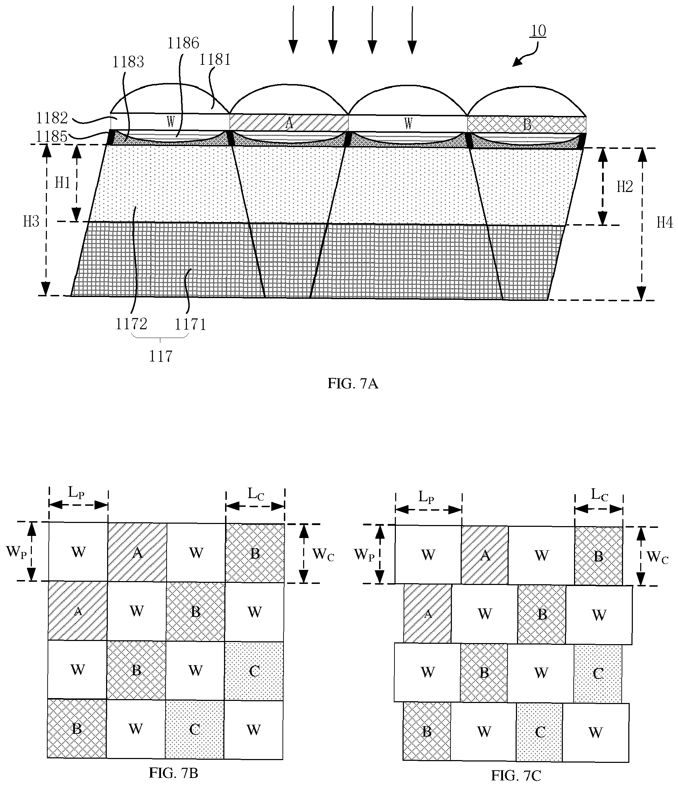

For example, FIGS. 7A to 7C are schematic diagrams showing a cross-sectional view of the pixel array 11 taken along the light-receiving direction, an arrangement of a plurality of filters 1182, and an arrangement of a plurality of photoelectric conversion elements 117 according to another embodiment of the present disclosure, respectively. As shown in FIG. 7A, in the light-receiving direction, the sizes of the plurality of cross-sections of the isolation layer 1183 of each panchromatic pixel (the same panchromatic pixel) gradually increase, and the sizes of the plurality of cross-sections of the isolation layer 1183 of each color pixel (the same color pixel) gradually decrease. The condenser lens 1186 is arranged within the isolation layer 1183. In the light-receiving direction, the sizes of the cross-sections of the n-potential well layer 1172 of each panchromatic pixel gradually increase, the sizes of the cross sections of the n-potential well layer 1172 of each color pixel gradually decreases, and the size of the smallest cross section of the n-potential well layer 1172 of the panchromatic pixel is equal to the size of the largest cross section of the n-potential well layer 1172 of the color pixel. The depth H1 of the n-potential well layer 1172 of the panchromatic pixel is equal to the depth H2 of the n-potential well layer 1172 of the color pixel. As shown in FIG. 7B, although the size of the cross section of the filter 1182 of the panchromatic pixel is equal to the size of the cross section of the filter 1182 of the color pixel (the area and the corresponding side lengths are equal), as shown in FIG. 7C, in fact, the size of the cross section (the cross section other than the smallest cross-section) of the n-potential well layer 1172 in the photoelectric conversion element 117 of the panchromatic pixel is greater than the size of the cross section of the n-potential well layer 1172 in the photoelectric conversion element 117 of the color pixel. In this way, the volume of the n-potential well layer 1172 of the panchromatic pixel is greater than the volume of the n-potential well layer 1172 of the color pixel, and the panchromatic pixel has a greater full well capacity than the color pixel. In addition, in the image sensor 10 shown in FIG. 7A, the condenser lens 1186 condenses light such that more light can enter the corresponding photoelectric conversion element 117, thereby avoiding the problem of optical cross interference.

In other embodiments, the size of the smallest cross section of the n-potential well layer 1172 of the panchromatic pixel in FIG. 7A may be greater than the size of the largest cross section of the n-potential well layer of the color pixel, and the depth H1 of the n-potential well layer 1172 of the panchromatic pixel may be greater than the depth H2 of the n-potential well layer 1172 of the color pixel.

For example, FIGS. 8A to 8C are schematic diagrams showing a cross-sectional view of the pixel array 11 taken along the light-receiving direction, an arrangement of a plurality of filters 1182, and an arrangement of a plurality of photoelectric conversion elements 117 according to another embodiment of the present disclosure, respectively. As shown in FIG. 8A, in the light-receiving direction, the sizes of the plurality of cross-sections of the isolation layer 1183 of each panchromatic pixel (the same panchromatic pixel) gradually increase, the sizes of the plurality of cross-sections of the isolation layer 1183 of each color pixel (the same color pixel) gradually decrease, and the size of the smallest cross section of the isolation layer 1183 of the panchromatic pixel is equal to the size of the largest cross section of the isolation layer 1183 of the color pixel. The condenser lens 1186 is arranged within the isolation layer 1183. In the light-receiving direction, the sizes of the plurality of cross-sections of the n-potential well layer 1172 of each pixel are all equal, the size of the cross section of the n-potential well layer 1172 of the panchromatic pixel is greater than the size of the cross section of the n-potential well layer 1172 of the color pixel. The depth H1 of the n-potential well layer 1172 of the panchromatic pixel is equal to the depth H2 of the n-potential well layer 1172 of the color pixel. As shown in FIG. 8B, although the size of the cross section of the filter 1182 of the panchromatic pixel is equal to the size of the cross section of the filter 1182 of the color pixel (the area and the corresponding side lengths are equal), as shown in FIG. 8C, in fact, the size of the cross section (the cross section other than the smallest cross section) of the n-potential well layer 1172 in the photoelectric conversion element 117 of the panchromatic pixel is greater than the size of the cross section of the n-potential well layer 1172 in the photoelectric conversion element 117 of the color pixel. In this way, the volume of the n-potential well layer 1172 of the panchromatic pixel is greater than the volume of the n-potential well layer 1172 of the color pixel, and the panchromatic pixel has a greater full well capacity than the color pixel. In addition, in the image sensor 10 shown in FIG. 8A, the condenser lens 1186 condenses light such that more light can enter the corresponding photoelectric conversion element 117, thereby avoiding the problem of optical cross interference.

In other embodiments, the depth H1 of the n-potential well layer 1172 of the panchromatic pixel in FIG. 8A may be greater than the depth H2 of the n-potential well layer 1172 of the color pixel, and the size of the smallest cross section of the isolation layer 1183 of the panchromatic pixel may be greater than the size of the largest cross section of the isolation layer 1183 of the color pixel.

In the image sensor 10 shown in any one of the embodiments of FIGS. 4A to 8C, each pixel is provided with a condenser lens 1186. When each pixel is provided with a condenser lens 1186, the condenser lenses 1186 with different curvature radii can be designed depending on requirements of different pixels. For example, the condenser lens 1186 of a color pixel may have a greater curvature radius than the condenser lens 1186 of a panchromatic pixel, such that the light-condensing ability of the condenser lens 1186 of the color pixel can be higher than the light-condensing ability of the condenser lens 1186 of the panchromatic pixel.

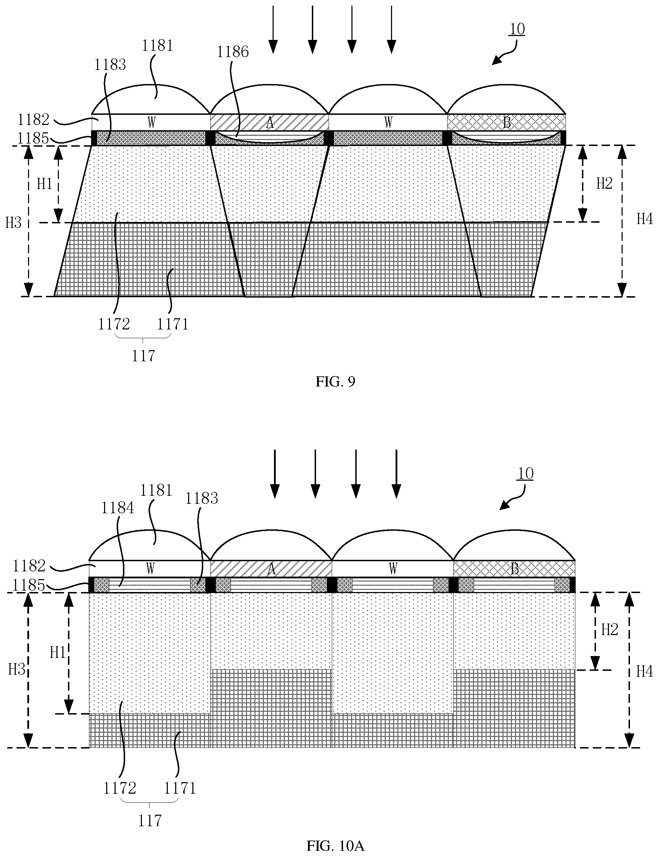

In other embodiments, only some of the pixels may each include a condenser lens 1186. The condenser lens 1186 may not be provided in the panchromatic pixel, and the condenser lens 1186 may be provided in the color pixel. For example, in the embodiment shown in FIG. 9, in the light-receiving direction, the cross section of the n-potential well layer 1172 of the panchromatic pixel gradually increases, and the cross section of the n-potential well layer of the color pixel gradually decreases, such that most of the light passing through the filter 1182 of the panchromatic pixel can enter the photoelectric conversion element 117 of the panchromatic pixel, while a small part of the light passing through the filter 1182 of the color pixel can enter the photoelectric conversion element 117of the color pixel. In this case, the condenser lens 1186 may be provided only in the isolation layer 1183 of the color pixel, such that the light-condensing effect of the condenser lens 1186 allows more light to enter the photoelectric conversion element 117 of the color pixel. By providing the condenser lenses 1186 only in some pixels, the manufacturing cost of the image sensor 10 can be reduced.

When a condenser lens 1186 is provided in a pixel, an anti-reflection film can be provided on the side of each condenser lens 1186 that faces towards the photoelectric conversion element 117. The anti-reflection film can reduce light interference and avoid the impact of the light interference on the imaging effect of the image sensor 10.

In the pixel array 11 in any one of the embodiments shown in FIGS. 4A to 8C, the depth H3 of the photoelectric conversion element 117 of the panchromatic pixel is equal to the depth H4 of the photoelectric conversion element 117 of the color pixel. Specifically, the depth H3 of the substrate 1171 of the panchromatic pixel is equal to the depth H4 of the substrate 1171 of the color pixel. When H3 and H4 are equal, the surface of the substrate 1171 of the panchromatic pixel that faces away from the filter 1182 and the surface of the substrate 1171 of the color pixel that faces away from the filter 1182 are in the same horizontal plane, which can reduce the complexity in the readout circuit design and manufacturing.

Each pixel in any one of the embodiments shown in FIGS. 4A to 8C may further include an optical isolation interlayer 1185. The optical isolation interlayer 1185 is arranged between the isolation layers 1183 of two adjacent pixels. For example, an optical isolation interlayer 1185 can be arranged between the isolation layer 1183 of the panchromatic pixel W and the isolation layer 1183 of the color pixel A, and another optical isolation interlayer 1185 can be arranged between the isolation layer 1183 of the panchromatic pixel W and the isolation layer 1183 of the color pixel B. The optical isolation interlayer 1185 may be made of at least one material selected from tungsten, titanium, aluminum, and copper. The optical isolation interlayer 1185 can prevent the light incident on a certain pixel from entering other pixels adjacent to the pixel, and avoid causing noise to the other pixels, i.e., avoid optical cross interference.

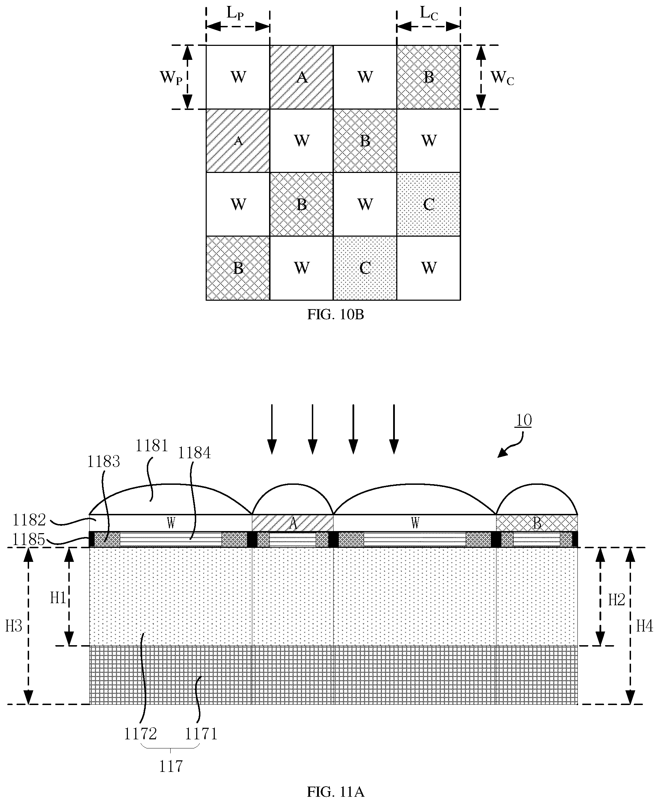

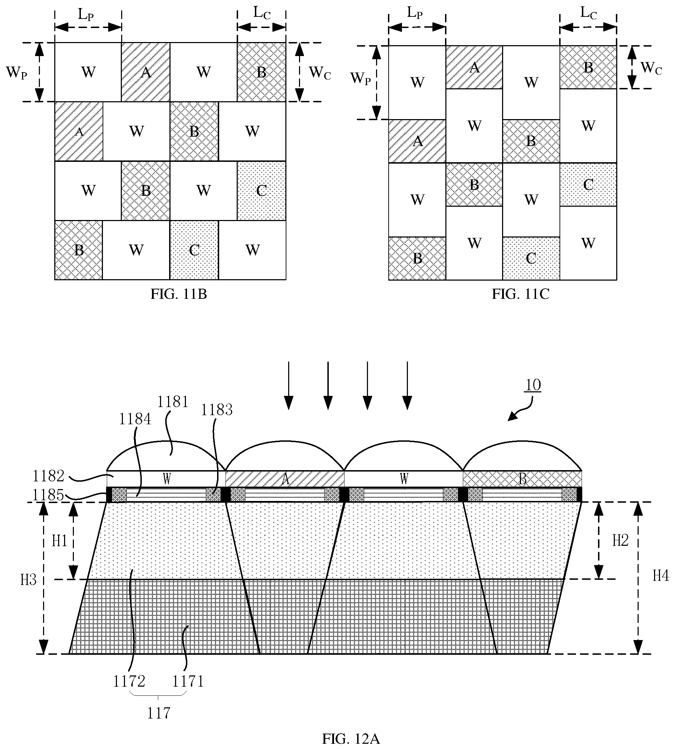

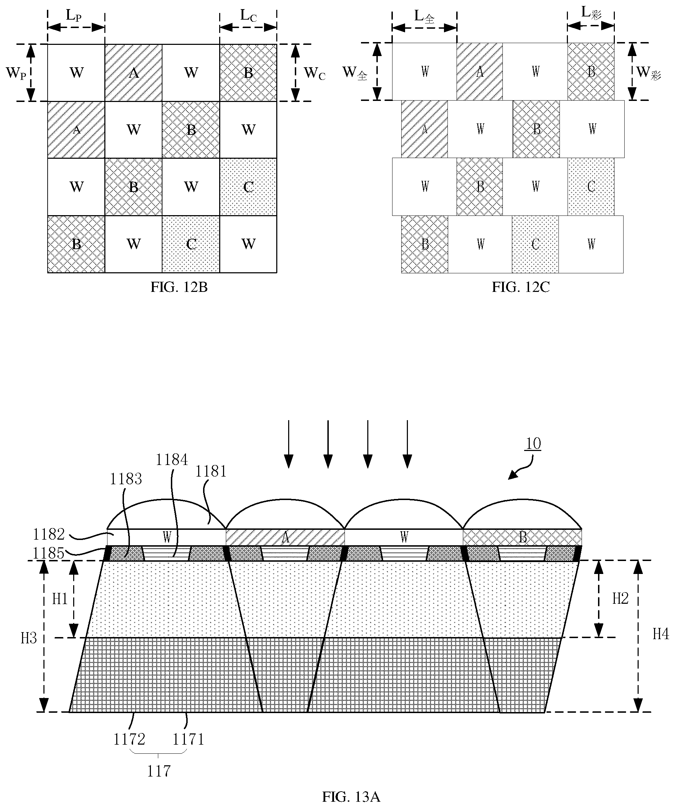

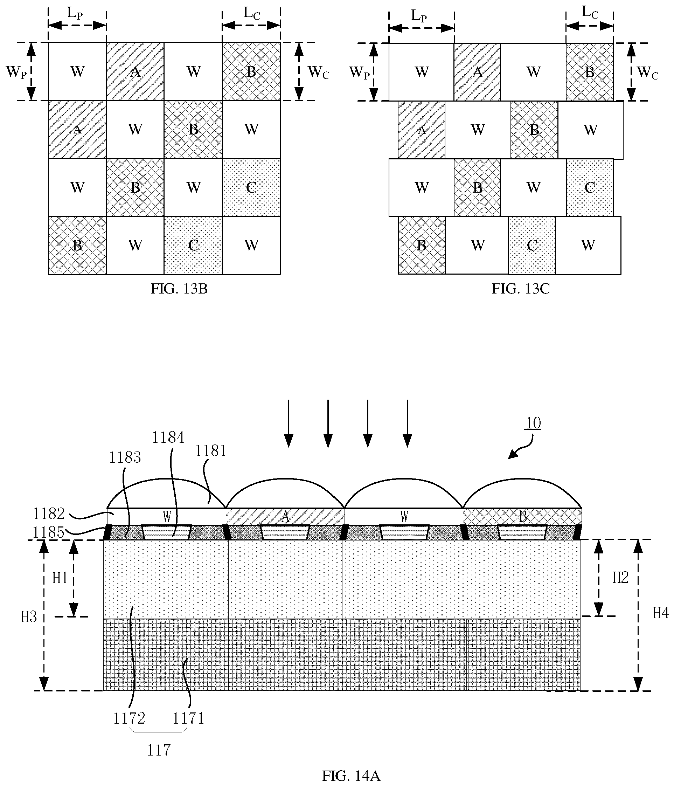

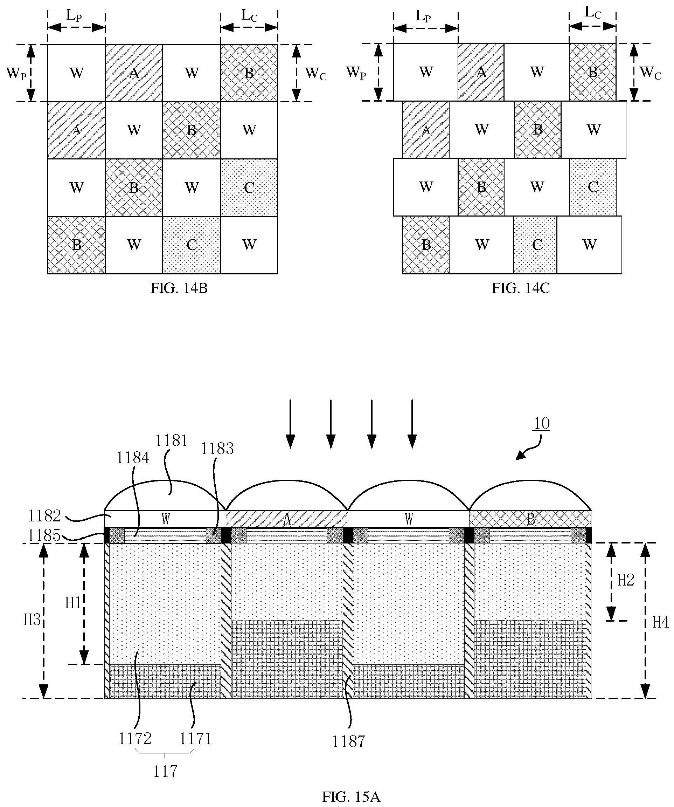

The condenser lens 1186 in each pixel in any of the embodiments shown in FIGS. 4A to 8C can be replaced with a light guide layer 1184. Specifically, as shown in FIGS. 10A to 14C, the structure of the image sensor 10 in FIG. 10A, except for the light guide layer 1184, is the same as that of the image sensor 10 in FIG. 4A, the structure of the image sensor 10 in FIG. 11A, except for the light guide layer 1184, is the same as that of the image sensor 10 in FIG. 5A, the structure of the image sensor 10 in FIG. 12A, except for the light guide layer 1184, is the same as that of FIG. 6A, the structure of the image sensor 10 in FIG. 13A, except for the light guide layer 1184, is the same as that of the image sensor 10 in FIG. 7A, and the structure of the image sensor 10 in FIG. 14A, except for the light guide layer 1184, is the same as that of the image sensor 10 in FIG. 8A. Here, the description of the microlens 1181, the filter 1182, the isolation layer 1183, the optical isolation interlayer 1185, and the photoelectric conversion element 117 (the substrate 1171 and the n-potential well layer 1172) will be omitted.

As shown in FIGS. 10A to 14C, the light guide layer 1184 is formed within the isolation layer 1183, and the refractive index of the light guide layer 1184 is greater than the refractive index of the isolation layer 1183. The isolation layer 1183 of each pixel, the light guide layer 1184 of the pixel, and the isolation layer 1183 of the pixel are sequentially arranged in the direction perpendicular to the light-receiving direction. For example, in the direction perpendicular to the light-receiving direction, the isolation layer 1183 of the panchromatic pixel W, the light guide layer 1184 of the panchromatic pixel W, and the isolation layer 1183 of the panchromatic pixel W are sequentially arranged, the isolation layer 1183 of the color pixel A, the light guide layer 1184 of the color pixel A, and the isolation layer 1183 of the color pixel A are sequentially arranged, the isolation layer 1183 of the color pixel B, the light guide layer 1184 of the color pixel B, and the isolation layer 1183 of the color pixel B are sequentially arranged. The purpose of providing the light guide layer 1184 in the isolation layer 1183 is to make the light passing through the filter 1182 be completely reflected in the structure composed of the isolation layer 1183 and the light guide layer 1184, so as to condense the light and allow more light to enter the corresponding photoelectric conversion element 117, thereby avoiding the problem of optical cross interference between adjacent pixels. The n-potential well layer 1172 in the photoelectric conversion element 117 may receive light passing through the light guide layer 1184 to convert the light into electric charges.

In an example, the refractive indexes at respective positions of the light guide layer 1184 are equal. This design scheme can simplify the design of the light guide layer and reduce the manufacturing difficulty of the pixel array 11. In another example, in the light-receiving direction of the image sensor 10, the refractive indexes of the light guide layer 1184 gradually increase. This design scheme can enhance the light-condensing ability of the light guide layer 1184, such that more light can enter the photoelectric conversion element 117.

As shown in FIGS. 10A to 12C, in the light-receiving direction, the sizes of the plurality of cross-sections of the isolation layer 1183 of each pixel are all equal, and the sizes of the plurality of cross-sections of the light guide layer 1184 of each pixel are also all equal. This design scheme can simplify the manufacturing process of the light guide layer 1184. Of course, in other embodiments, when the sizes of the plurality of cross-sections of the isolation layer 1183 of each pixel are all equal in the light-receiving direction, the structure of the light guide layer 1184 may have the sizes of the plurality of cross-sections of the light guide layer 1184 of each pixel gradually decreasing in the light-receiving direction. This design scheme can enhance the light-condensing ability of the light guide layer 1184, such that more light can enter the photoelectric conversion element 117.

As shown in FIGS. 13A and 14A, in the light-receiving direction, the sizes of the plurality of cross-sections of the isolation layer 1183 of each panchromatic pixel gradually increase, the sizes of the plurality of cross-sections of the isolation layer 1183 of each color pixel gradually decrease, and the sizes of the cross sections of the light guide layer 1184 of each panchromatic pixel and the light guide layer 1184 of each color pixel gradually decrease. This design scheme can enhance the light-condensing ability of the light guide layer 1184, such that more light can enter the photoelectric conversion element 117. Of course, in other embodiments, when the sizes of the plurality of cross-sections of the isolation layer 1183 of each panchromatic pixel gradually increase and the sizes of the plurality of cross-sections of the isolation layer 1183 of each color pixel gradually decrease in the light-receiving direction, the structure of the light guide layer 1184 may have the sizes of the plurality of cross-sections of the isolation layer 1183 of each pixel being all equal in the light-receiving direction. This design scheme can simplify the manufacturing process of the light guide layer 1184.

The depth of the light guide layer 1184 is equal to the depth of the isolation layer 1183, such that the light-receiving ability of the light guide layer 1184 can be enhanced. Compared with the thickness of the isolation layer in the existing image sensor, the thickness of the isolation layer 1183 of the present disclosure is greater, e.g., greater than a predetermined thickness, so as to form a longer optical path and improve the light-condensing effect of the structure composed of the light guide layer 1184 and the isolation layer 1183.

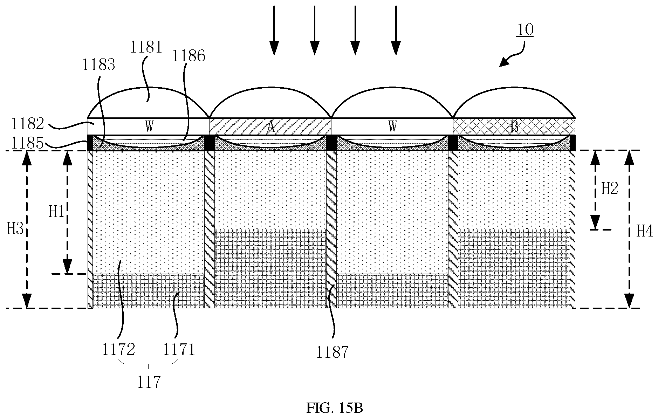

Referring to FIGS. 15A and 15B, the image sensor 10 may further include a barrier layer 1187. The barrier layer 1187 may be provided between the photoelectric conversion elements 117 of two adjacent pixels. For example, one barrier layer 1187 may be provided between the photoelectric conversion element 117 of the panchromatic pixel W and the photoelectric conversion element 117 of the color pixel A, and another barrier layer 1187 may be provided between the photoelectric conversion element 117 of the panchromatic pixel W and the photoelectric conversion element 117 of the color pixel B, and so on. For example, the barrier layer 1187 may be a Deep Trench Isolation (DTI). The barrier layer 1187 can prevent the light entering the photoelectric conversion element 117 of a certain pixel from entering the photoelectric conversion element 117 of other pixels adjacent to the pixel, and avoid causing noise to the photoelectric conversion element 117 of the other pixels.

In addition to setting the full well capacity of the panchromatic pixel to be greater than the full well capacity of the color pixel as described above, in an embodiment of the present disclosure, different full well capacities can also be set for color pixels of different colors. Specifically, the full well capacity corresponding to the sensitivity of the color pixel can be set based on the sensitivity of the color pixel (the shorter the time for the pixel to reach the saturated exposure amount, the higher the sensitivity). For example, as shown in FIG. 1, the sensitivity of the green pixel>the sensitivity of the red pixel>the sensitivity of the blue pixel, and the full well capacities of the color pixels can be set as: the full well capacity of the green pixel>the full well capacity of the red pixel>the full well capacity of the blue pixel. Here, the scheme for increasing the full well capacity of a color pixel is similar to the scheme for increasing the full well capacity of a panchromatic pixel. For example, one scheme may be as follows: when the cross-sectional areas of the n-potential well layers 1172 of the pixels are the same, that is, S_{W}=S_{G}=S_{R}=S_{B}, the relation between the depths of the n-potential well layers 1172 of the pixels can be H_{W}>H_{G}>H_{R}>H_{B}. In another example, when the depths of the n-potential well layers 1172 of the pixels are the same, that is, H_{W}=H_{G}=H_{R}=H_{B}, the relation between the cross-sectional areas of the n-potential well layers 1172 of the pixels may be S_{W}>S_{G}>S_{R}>S_{B}. Description of other situations will be omitted here. In this way, different full well capacities can be set based on different sensitivities, such that the exposure of pixels of different colors can be balanced and the quality of the captured image can be improved.

In addition to setting the full well capacity of the panchromatic pixel to be greater than the full well capacity of the color pixel, the exposure time of the panchromatic pixel and the exposure time of the color pixel can be controlled separately to balance the exposure of the panchromatic pixel and the color pixel.

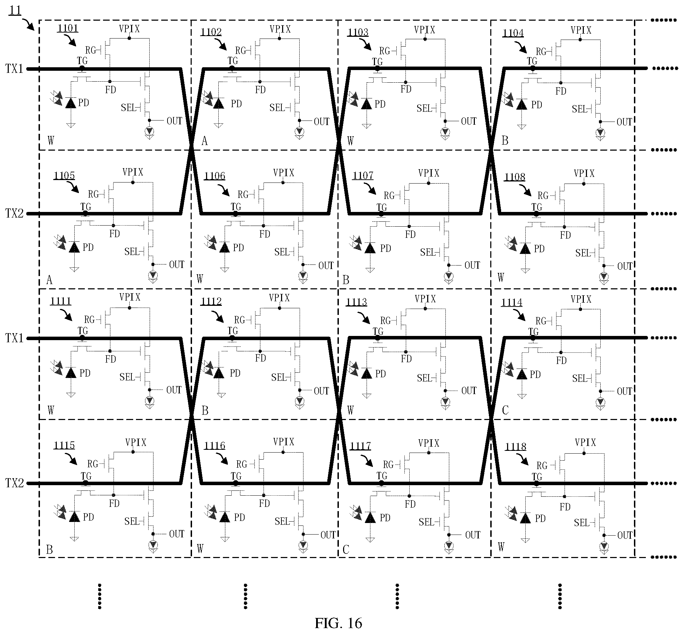

FIG. 16 is a schematic diagram showing a pixel array 11 and a connection scheme of exposure control lines according to an embodiment of the present disclosure. The pixel array 11 is a two-dimensional pixel array. The two-dimensional pixel array includes a plurality of panchromatic pixels and a plurality of color pixels. Each color pixel has a narrower spectral response than each panchromatic pixel. The arrangement of the pixels in the pixel array 11 is as follows:
W A W B
A W B W
W B W C
B W C W.

It is to be noted that, for the convenience of illustration, only some pixels in the pixel array 11 are shown in FIG. 16, and other surrounding pixels and connecting lines are replaced by the ellipsis "...".

As shown in FIG. 16, pixels 1101, 1103, 1106, 1108, 1111, 1113, 1116, and 1118 are panchromatic pixels W, pixels 1102, 1105 are first color pixels A (for example, red pixels R), pixels 1104, 1107, 1112 and 1115 are second color pixels B (for example, green pixels G), and pixels 1114 and 1117 are third color pixels C (for example, blue pixels Bu). It can be seen from FIG. 16 that the control terminal TG of the exposure control circuit in each panchromatic pixel W (pixels 1101, 1103, 1106, and 1108) is connected to a first exposure control line TX1, and the control terminal TG of the exposure control circuit in each panchromatic pixel W (1111, 1113, 1116, and 1118) is connected to another first exposure control line TX1. The control terminal TG of the exposure control circuit in each first color pixel A (pixels 1102 and 1105) and the control terminal TG of the exposure control circuit in each second color pixel B (pixels 1104 and 1107) are connected to a second exposure control line TX2. The control terminal TG of the exposure control circuit in each second color pixel B (pixels 1112 and 1115) and the control terminal TG of the exposure control circuit in each third color pixel C (pixels 1114 and 1117) are connected to another second exposure control line TX2. Each first exposure control line TX1 can control the exposure time length of the panchromatic pixels using a first exposure control signal. Each second exposure control line TX2 can control the exposure time length of the color pixels (such as the first color pixels A and the second color pixels B, and the second-color pixels B and the third-color pixels C) using a second exposure control signal. This enables separate control of the exposure time lengths of the panchromatic pixels and the color pixels. For example, it is possible that when the exposure of the panchromatic pixels ends, the color pixels continue to be exposed to achieve an ideal imaging effect.

Referring to FIGS. 2 and 16, the first exposure control line TX1 and the second exposure control line TX2 are connected to the vertical driving unit 12 in FIG. 2, and the corresponding exposure control signals in the vertical driving unit 12 are transmitted to the control terminals TG of the exposure control circuits of the pixels in the pixel array 11.

It can be appreciated that, since there are a plurality of pixel row groups in the pixel array 11, the vertical driving unit 12 is connected to a plurality of first exposure control lines TX1 and a plurality of second exposure control lines TX2 each corresponding to a pixel row group.

For example, the first first exposure control line TX1 corresponds to the panchromatic pixels in the first row and the second row; the second first exposure control line TX1 corresponds to the panchromatic pixels in the third row and the fourth row, and so on. The third first exposure control line TX1 corresponds to the panchromatic pixels in the fifth and sixth rows; the fourth first exposure control line TX1 corresponds to the panchromatic pixels in the seventh and eighth rows, and the correspondence between further first exposure control lines TX1 and the panchromatic pixels in further rows will be omitted here. The timing sequences of the signals transmitted by different first exposure control lines TX1 are also different, and the timing sequences of the signals are configured by the vertical driving unit 12.

For example, the first second exposure control line TX2 corresponds to the color pixels in the first and second rows; the second second exposure control line TX2 corresponds to the color pixels in the third and fourth rows, and so on. The third second exposure control line TX2 corresponds to the color pixels in the fifth and sixth rows; the fourth second exposure control line TX2 corresponds to the color pixels in the seventh and eighth rows, and the correspondence between further second exposure control lines TX2 and the color pixels in further rows will be omitted here. The timing sequences of the signals transmitted by different second exposure control lines TX2 are also different, and the timing sequences of the signals are configured by the vertical driving unit 12.

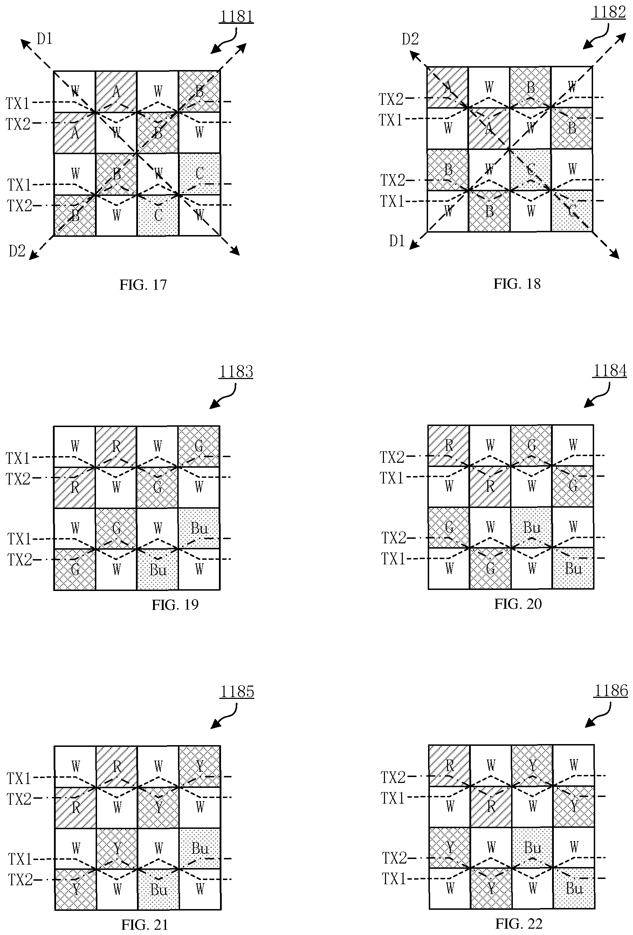

FIGS. 17 to 32 show examples of pixel arrangements in various image sensors 10 (shown in FIG. 2). Referring to FIGS. 2 and 17 to 32, the image sensor 10 includes a two-dimensional pixel array (that is, the pixel array 11 shown in FIG. 16) composed of a plurality of color pixels (for example, a plurality of first color pixels A, a plurality of second color pixels B, and a plurality of third color pixels C) and a plurality of panchromatic pixels W. Here, the color pixel has a narrower spectral response than the panchromatic pixel. The response spectrum of the color pixel may be, for example, a part of the response spectrum of the panchromatic pixel W. The two-dimensional pixel array includes minimum repeated units (FIGS. 17 to 32 show examples of minimum repeated units of pixels in various image sensors 10). The two-dimensional pixel array is composed of a plurality of minimum repeated units duplicated and arranged in rows and columns. In the minimum repeated unit, the panchromatic pixels W are arranged in a first diagonal direction D1, and the color pixels are arranged in a second diagonal direction D2 different from the first diagonal direction D1. First exposure time of at least two color pixels adjacent in the first diagonal direction D1 is controlled by a first exposure signal, and second exposure time of at least two color pixels adjacent in the second diagonal direction D2 is controlled by a second exposure signal, so as to provide separate control of the exposure time of the panchromatic pixels and the exposure time of the color pixels. Each minimum repeated unit includes a plurality of subunits, and each subunit includes a plurality of monochromatic pixels (for example, a plurality of first-color pixels A, a plurality of second-color pixels B, or a plurality of third-color pixels C) and a plurality of panchromatic pixels W. For example, referring to FIG. 2 and FIG. 16, pixels 1101to 1108 and pixels 1111 to 1118 form a minimum repeated unit, where pixels 1101, 1103, 1106, 1108, 1111, 1113, 1116, and 1118 are panchromatic pixels, and pixel 1102, 1104, 1105, 1107, 1112, 1114, 1115, and 1117 are color pixels. Pixels 1101, 1102, 1105, and 1106 form a subunit, where pixels 1101 and 1106 are panchromatic pixels, and pixels 1102 and 1105 are monochromatic pixels (for example, first color pixels A). Pixels 1103, 1104, 1107, and 1108 form a subunit, where pixels 1103 and 1108 are panchromatic pixels, and the pixels 1104 and 1107 are monochromatic pixels (for example, second color pixels B). Pixels 1111, 1112, 1115, and 1116 form a subunit, where pixels 1111 and 1116 are panchromatic pixels, and pixels 1112 and 1115 are monochromatic pixels (for example, second-color pixels B). Pixels 1113, 1114, 1117, and 1118 form a subunit, where pixels 1113 and 1118 are panchromatic pixels, and pixels 1114 and 1117 are monochromatic pixels (for example, third-color pixels C).

For example, the number of pixel rows and the number of pixel columns in the minimum repeated unit may be equal. For example, the minimum repeated units may include, but be not limited to, minimum repeated units of 4 rows and 4 columns, 6 rows and 6 columns, 8 rows and 8 columns, and 10 rows and 10 columns. For example, the number of pixel rows and the number of pixel columns in the subunit in the minimum repeated unit may be equal. For example, the subunits may include, but be not limited to, the subunits of 2 rows and 2 columns, 3 rows and 3 columns, 4 rows and 4 columns, and 5 rows and 5 columns. This setting helps balance the resolution and color performance of the image in the row and column directions, thereby improving the display effect.

For example, FIG. 17 is a schematic diagram showing a pixel arrangement of a minimum repeated unit 1181 in an embodiment of the present disclosure. The minimum repeated unit has 16 pixels arranged in 4 rows and 4 columns, and each subunit has 4 pixels arranged in 2 rows and 2 columns. The arrangement is:
W A W B
A W B W
W B W C
B W C W,
where W represents a panchromatic pixel, A represents a first color pixel of a plurality of color pixels, B represents a second color pixel of a plurality of color pixels, and C represents a third color pixel of a plurality of color pixels.

For example, as shown in FIG. 17, the panchromatic pixels W are arranged in the first diagonal direction D1 (that is, the direction connecting the upper left corner and the lower right corner in FIG. 17), and the color pixels are arranged in the second diagonal direction D2 (for example, the direction connecting the lower left corner and the upper right corner as shown in FIG. 17). The first diagonal direction D1 is different from the second diagonal direction D2. For example, the first diagonal and the second diagonal are perpendicular to each other. The first exposure time of two adjacent panchromatic pixels W in the first diagonal direction D1 (for example, the two panchromatic pixels in the first row, first column and in the second row, second column from the upper left) is controlled by the first exposure signal, the second exposure time of at least two adjacent color pixels in the second diagonal direction D2 (for example, two color pixels B in the fourth row, first column and in the third row, second column from the upper left) is controlled by the second exposure signal.

It is to be noted that the first diagonal direction D1 and the second diagonal direction D2 are not limited to the diagonals, but may also include directions parallel to the diagonals. For example, in FIG. 16, the panchromatic pixels 1101, 1106, 1113 and 1118 are arranged in the first diagonal direction D1, the panchromatic pixels 1103 and 1108 are also arranged in the first diagonal direction D1, and the panchromatic pixels 1111 and 1116 are also arranged in the first diagonal direction D1. The color pixels 1104, 1107, 1112, and 1115 are arranged in the second diagonal direction D2, the first color pixels 1102 and 1105 are also arranged in the second diagonal direction D2, and the third color pixels 1114 and 1117 are also arranged in the second diagonal direction D2. Such explanation of the first diagonal direction D1 and the second diagonal direction D2 also applies to FIGS. 18 to 32 below. The "direction" here is not a single direction, but can be understood as a concept of "straight line" indicating an arrangement, and there may be two-way directions for both ends of the straight line.

It can be appreciated that the orientation or positional relation indicated by the terms "upper", "lower", "left", "right", etc. here and below is the orientation or positional relation shown in the drawings, which is only for convenience in describing the present disclosure and simplifying the description, rather than indicating or implying that the apparatus or element referred to must have any specific orientation or be constructed and operated in any specific orientation, and therefore cannot be understood as a limitation on the present disclosure.

For example, as shown in FIG. 17, the panchromatic pixels in the first row and the second row are connected together by the first exposure control line TX1 in the shape of "W" to provide separate control of the exposure time of the panchromatic pixels. The color pixels (A and B) in the first row and the second row are connected together by the second exposure control line TX2 in the shape of "W" to provide separate control of the exposure time of the color pixels. The panchromatic pixels in the third row and the fourth row are connected together by the first exposure control line TX1 in the shape of "W" to provide separate control of the exposure time of the panchromatic pixels. The color pixels (B and C) of the third row and the fourth row are connected together by the second exposure control line TX2 in the shape of "W" to provide separate control of the exposure time of the color pixels. For example, the first exposure signal is transmitted via the first exposure control line TX1, and the second exposure signal is transmitted via the second exposure control line TX2. For example, the first exposure control line TX1 is in the shape of "W" and is electrically connected to the control terminals of the exposure control circuits in the panchromatic pixels in two adjacent rows. The second exposure control line TX2 is in the shape of "W" and is electrically connected to the control terminals of the exposure control circuits in the color pixels in two adjacent rows. For the specific connection scheme, reference can be made to the description of the connections and the pixel circuits in the relevant parts of FIG. 2 and FIG. 16.

It is to be noted that the "W" shapes of the first exposure control line TX1 and the second exposure control line TX2 do not mean that the physical wirings must be set strictly in accordance with the "W" shapes, as long as the connection scheme corresponds to the arrangement of the panchromatic pixels and the color pixels. For example, the "W"-shape setting of the exposure control line corresponds to the "W"-shape pixel arrangement. This setting is simple in wiring and has good effects in resolution and color of the pixel arrangement, so as to provide independent control of exposure time for the panchromatic pixels and the color pixels at a low cost.

For example, FIG. 18 is a schematic diagram showing a pixel arrangement of another minimum repeated unit 1182 in an embodiment of the present disclosure. The minimum repeated unit has 16 pixels in 4 rows by 4 columns, and each subunit has 4 pixels in 2 rows by 2 columns. The arrangement is:
A W B W
W A W B
B W C W
W B W C,
where W represents a panchromatic pixel, A represents a first color pixel of a plurality of color pixels, B represents a second color pixel of a plurality of color pixels, and C represents a third color pixel of a plurality of color pixels.

For example, as shown in FIG. 18, the panchromatic pixels Ws are arranged in the first diagonal direction D1 (that is, the direction connecting the upper right corner and the lower left corner in FIG. 18), and the color pixels are arranged in the second diagonal direction D2 (for example, the direction of the connection between the upper left corner and the lower right corner as shown in FIG. 18). For example, the first diagonal line and the second diagonal line are perpendicular to each other. The first exposure time of two adjacent panchromatic pixels W in the first diagonal direction D1 (for example, two panchromatic pixels in the first row, second column and in the second row, first column from the upper left) is controlled by the first exposure signal, the second exposure time of at least two adjacent color pixels in the second diagonal direction (for example, two color pixels A in the first row, first column and in the second row, second column from the upper left) is controlled by the second exposure signal.

For example, as shown in FIG. 18, the panchromatic pixels in the first row and the second row are connected together by the first exposure control line TX1 in the shape of "W" to provide separate control of the exposure time of the panchromatic pixels. The color pixels (A and B) in the first row and the second row are connected together by the second exposure control line TX2 in the shape of "W" to provide separate control of the exposure time of the color pixels. The panchromatic pixels in the third row and the fourth row are connected together by the first exposure control line TX1 in the shape of "W" to provide separate control of the exposure time of the panchromatic pixels. The color pixels (B and C) in the third row and the fourth row are connected together by the second exposure control line TX2 in the shape of "W" to provide separate control of the exposure time of the color pixels.

For example, FIG. 19 is a schematic diagram showing a pixel arrangement of another minimum repeated unit 1183 in an embodiment of the present disclosure. FIG. 20 is a schematic diagram showing a pixel arrangement of another minimum repeated unit 1184 in an embodiment of the present disclosure. In the embodiments of FIGS. 19 and 20, corresponding to the arrangements of FIGS. 17 and 18, the first color pixel A is a red pixel R, the second color pixel B is a green pixel G; and the third color pixel C is a blue pixel Bu.

It is to be noted that, in some embodiments, the response band of the panchromatic pixel W is a visible light band (for example, 400 nm to 760 nm). For example, the panchromatic pixel W is provided with an infrared filter to filter out infrared light. In some embodiments, the response bands of the panchromatic pixel W is a visible light band and a near-infrared band (for example, 400 nm to 1000 nm), which matches the response bands of the photoelectric conversion element 117 (for example, photodiode PD) in the image sensor 10. For example, the panchromatic pixel W may not be provided with a filter, and the response band of the panchromatic pixel W may depend on (i.e., match) the response band of the photodiode. The embodiments of the present disclosure may include, but be not limited to, the above band range.

For example, FIG. 21 is a schematic diagram showing a pixel arrangement of another minimum repeated unit 1185 in an embodiment of the present disclosure. FIG. 22 is a schematic diagram of a pixel arrangement of another minimum repeated unit 1186 in an embodiment of the present disclosure. In the embodiments of FIG. 21 and FIG. 22, corresponding to the arrangements of FIG. 17 and FIG. 18, the first color pixel A is a red pixel R, the second color pixel B is a yellow pixel Y, and the third color pixel C is a blue pixel Bu.

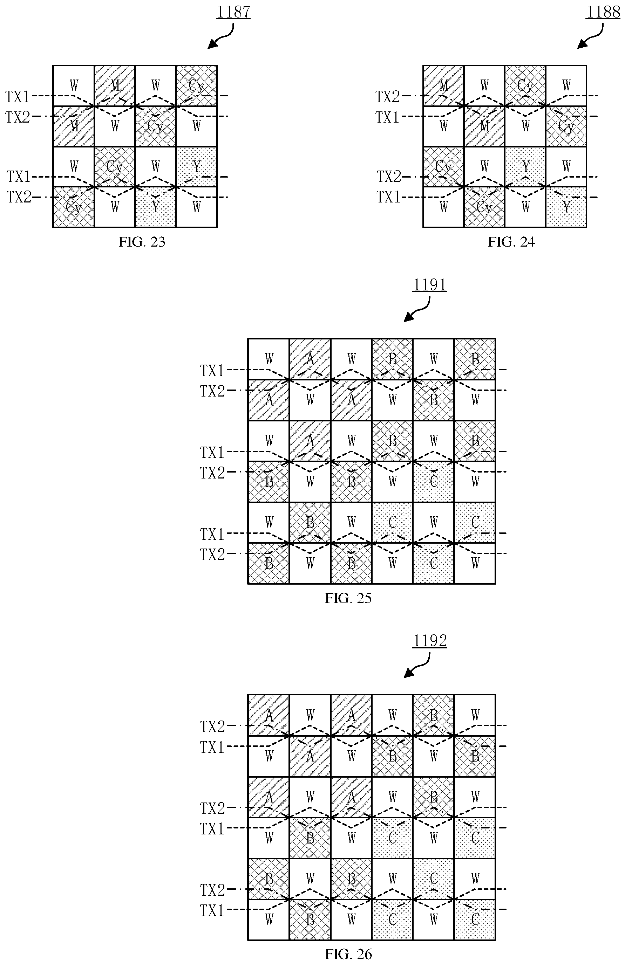

For example, FIG. 23 is a schematic diagram showing a pixel arrangement of another minimum repeated unit 1187 in an embodiment of the present disclosure. FIG. 24 is a schematic diagram showing a pixel arrangement in another minimum repeated unit 1188 in an embodiment of the present disclosure. In the embodiments of FIGS. 23 and 24, corresponding to the arrangements of FIGS. 17 and 18, the first color pixel A is a magenta pixel M; the second color pixel B is a cyan pixel Cy, and the third color pixel C is a yellow pixel Y.

For example, FIG. 25 is a schematic diagram showing a pixel arrangement of another minimum repeated unit 1191 in an embodiment of the present disclosure. The minimum repeated unit has 36 pixels in 6 rows by 6 columns, and each subunit has 9 pixels in 3 rows by 3 columns. The arrangement is:
W A W B W B
A W A W B W
W A W B W B
B W B W C W
W B W C W C
B W B W C W,
where W represents a panchromatic pixel, A represents a first color pixel of a plurality of color pixels, B represents a second color pixel of a plurality of color pixels, and C represents a third color pixel of a plurality of color pixels.

For example, as shown in FIG. 25, the panchromatic pixels in the first row and the second row are connected together by the first exposure control line TX1 in the shape of "W" to provide separate control of the exposure time of the panchromatic pixels. The color pixels (A and B) in the first row and the second row are connected together by the second exposure control line TX2 in the shape of "W" to provide separate control of the exposure time of the color pixels. The panchromatic pixels in the third row and the fourth row are connected together by the first exposure control line TX1 in the shape of "W" to provide separate control of the exposure time of the panchromatic pixels. The color pixels (A, B, and C) in the third and fourth rows are connected together by the second exposure control line TX2 in the shape of "W" to provide separate control of the exposure time of the color pixels. The panchromatic pixels in the fifth row and the sixth row are connected together by the first exposure control line TX1 in the shape of "W" to provide separate control of the exposure time of the panchromatic pixels. The color pixels (B and C) in the fifth row and the sixth row are connected together by the second exposure control line TX2 in the shape of "W" to provide separate control of the exposure time of the color pixels.

For example, FIG. 26 is a schematic diagram showing a pixel arrangement of another minimum repeated unit 1192 in an embodiment of the present disclosure. The minimum repeated unit is 36 pixels in 6 rows by 6 columns, and each subunit has 9 pixels in 3 rows by 3 columns. The arrangement is:
A W A W B W
W A W B W B
A W A W B W
W B W C W C
B W B W C W
W B W C W C,
where W represents a panchromatic pixel, A represents a first color pixel of a plurality of color pixels, B represents a second color pixel of a plurality of color pixels, and C represents a third color pixel of a plurality of color pixels.

For example, as shown in FIG. 26, the panchromatic pixels in the first row and the second row are connected together by the first exposure control line TX1 in the shape of "W" to provide separate control of the exposure time of the panchromatic pixels. The color pixels (A and B) in the first row and the second row are connected together by the second exposure control line TX2 in the shape of "W" to provide separate control of the exposure time of the color pixels. The panchromatic pixels in the third row and the fourth row are connected together by the first exposure control line TX1 in the shape of "W" to provide separate control of the exposure time of the panchromatic pixels. The color pixels (A, B, and C) in the third and fourth rows are connected together by the second exposure control line TX2 in the shape of "W" to provide separate control of the exposure time of the color pixels. The panchromatic pixels in the fifth row and the sixth row are connected together by the first exposure control line TX1 in the shape of "W" to provide separate control of the exposure time of the panchromatic pixels. The color pixels (B and C) in the fifth row and the sixth row are connected together by the second exposure control line TX2 in the shape of "W" to provide separate control of the exposure time of the color pixels.

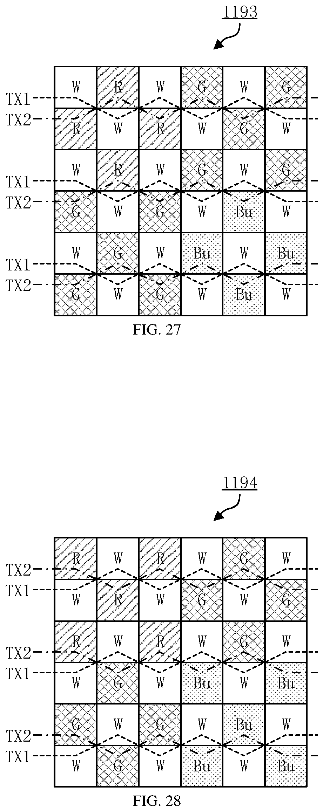

For example, FIG. 27 is a schematic diagram showing a pixel arrangement of another minimum repeated unit 1193 in an embodiment of the present disclosure. FIG. 28 is a schematic diagram showing a pixel arrangement of another minimum repeated unit 1194 in an embodiment of the present disclosure. In the embodiments of FIG. 27 and FIG. 28, corresponding to the arrangements of FIG. 25 and FIG. 26, the first color pixel A is a red pixel R, the second color pixel B is a green pixel G, and the third color pixel C is a blue pixel Bu.

For example, in other embodiments, the first color pixel A may be a red pixel R, the second color pixel B may be a yellow pixel Y, and the third color pixel C may be a blue pixel Bu. For example, in other embodiments, the first color pixel A may be a magenta pixel M, the second color pixel B may be a cyan pixel Cy, and the third color pixel C is a yellow pixel Y. The embodiments of the present disclosure include but are not limited to any of these examples. For the specific connection scheme of the circuits, reference can be made to the above description, and details thereof will be omitted here.

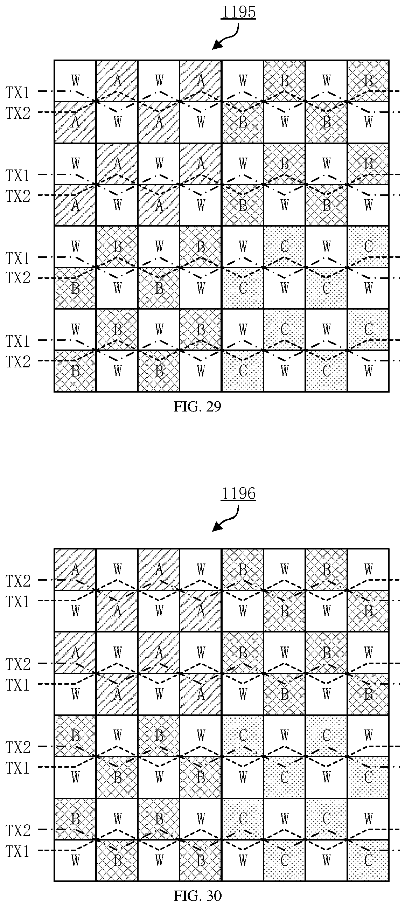

For example, FIG. 29 is a schematic diagram of a pixel arrangement of another minimum repeated unit 1195 in an embodiment of the present disclosure. The minimum repeated unit has 64 pixels in 8 rows by 8 columns, and each subunit has 16 pixels in 4 rows by 4 columns. The arrangement is:
WAWAWBWB
AWAWBWBW
WAWAWBWB
AWAWBWBW
WBWBWCWC
BWBWCWCW
WBWBWCWC
BWBWCWCW,
where W represents a panchromatic pixel, A represents a first color pixel of a plurality of color pixels, B represents a second color pixel of a plurality of color pixels, and C represents a third color pixel of a plurality of color pixels.

For example, as shown in FIG. 29, the panchromatic pixels in the first row and the second row are connected together by the first exposure control line TX1 in the shape of "W" to provide separate control of the exposure time of the panchromatic pixels. The color pixels (A and B) in the first row and the second row are connected together by the second exposure control line TX2 in the shape of "W" to provide separate control of the exposure time of the color pixels. The panchromatic pixels in the third row and the fourth row are connected together by the first exposure control line TX1 in the shape of "W" to provide separate control of the exposure time of the panchromatic pixels. The color pixels (A and B) of the third row and the fourth row are connected together by the second exposure control line TX2 in the shape of "W" to provide separate control of the exposure time of the color pixels. The panchromatic pixels in the fifth row and the sixth row are connected together by the first exposure control line TX1 in the shape of "W" to provide separate control of the exposure time of the panchromatic pixels. The color pixels (B and C) in the fifth row and the sixth row are connected together by the second exposure control line TX2 in the shape of "W" to provide separate control of the exposure time of the color pixels. The panchromatic pixels in the seventh row and the eighth row are connected together by the first exposure control line TX1 in the shape of "W" to provide separate control of the exposure time of the panchromatic pixels. The color pixels (B and C) in the seventh row and the eighth row are connected together by the second exposure control line TX2 in the shape of "W" to provide separate control of the exposure time of the color pixels.

For example, FIG. 30 is a schematic diagram showing a pixel arrangement of another minimum repeated unit 1196 in an embodiment of the present disclosure. The minimum repeated unit has 64 pixels in 8 rows by 8 columns, and each subunit has 16 pixels in 4 rows by 4 columns. The arrangement is:
A W A W B W B W
W A W A W B W B
A W A W B W B W
W A W A W B W B
BWBWCWCW
WBWBWCWC
BWBWCWCW
WBWBWCWC,
where W represents a panchromatic pixel, A represents a first color pixel of a plurality of color pixels, B represents a second color pixel of a plurality of color pixels, and C represents a third color pixel of a plurality of color pixels.

For example, as shown in FIG. 30, the panchromatic pixels in the first row and the second row are connected together by the first exposure control line TX1 in the shape of "W" to provide separate control of the exposure time of the panchromatic pixels. The color pixels (A and B) in the first row and the second row are connected together by the second exposure control line TX2 in the shape of "W" to provide separate control of the exposure time of the color pixels. The panchromatic pixels in the third row and the fourth row are connected together by the first exposure control line TX1 in the shape of "W" to provide separate control of the exposure time of the panchromatic pixels. The color pixels (A and B) of the third row and the fourth row are connected together by the second exposure control line TX2 in the shape of "W" to provide separate control of the exposure time of the color pixels. The panchromatic pixels in the fifth row and the sixth row are connected together by the first exposure control line TX1 in the shape of "W" to provide separate control of the exposure time of the panchromatic pixels. The color pixels (B and C) in the fifth row and the sixth row are connected together by the second exposure control line TX2 in the shape of "W" to provide separate control of the exposure time of the color pixels. The panchromatic pixels in the seventh row and the eighth row are connected together by the first exposure control line TX1 in the shape of "W" to provide separate control of the exposure time of the panchromatic pixels. The color pixels (B and C) in the seventh row and the eighth row are connected together by the second exposure control line TX2 in the shape of "W" to provide separate control of the exposure time of the color pixels.

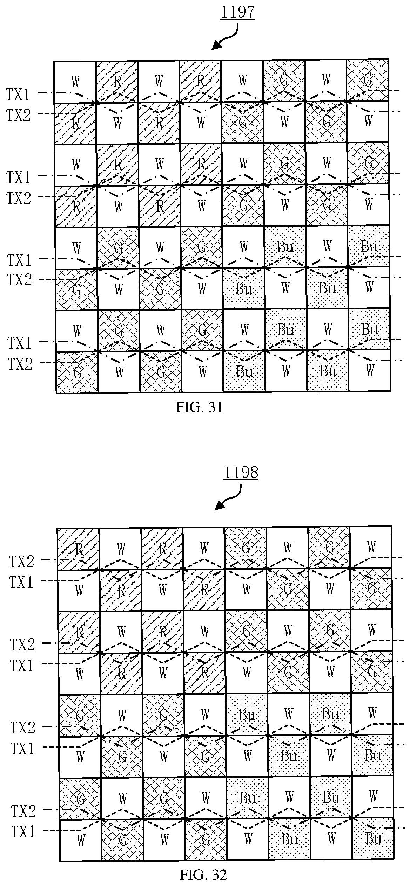

For example, FIG. 31 is a schematic diagram showing a pixel arrangement of another minimum repeated unit 1197 in an embodiment of the present disclosure. FIG. 32 is a schematic diagram showing a pixel arrangement of another minimum repeated unit 1198 in an embodiment of the present disclosure. In the embodiments of FIGS. 31 and 32, corresponding to the arrangements of FIGS. 29 and 30, the first color pixel A is a red pixel R, the second color pixel B is a green pixel G, and the third color pixel C is a blue pixel Bu.

For example, in other embodiments, the first color pixel A may be a red pixel R, the second color pixel B may be a yellow pixel Y, and the third color pixel C may be a blue pixel Bu. For example, the first color pixel A may be a magenta pixel M, the second color pixel B may be a cyan pixel Cy, and the third color pixel C may be a yellow pixel Y. The embodiments of the present disclosure include but are not limited to any of these examples. For the specific connection scheme of the circuits, reference can be made to the above description, and details thereof will be omitted here.

It can be seen from the above embodiments that, as shown in FIGS. 17 to 32, the image sensor 10 (shown in FIG. 2) includes a plurality of color pixels and a plurality of panchromatic pixels W arranged in a matrix, the color pixels and the panchromatic pixels are arranged alternately in both the row and column directions.

For example, a panchromatic pixel, a color pixel, a panchromatic pixel, a color pixel, and so on, are alternately arranged in the row direction.

For example, a panchromatic pixel, a color pixel, a panchromatic pixel, a color pixel, and so on, are alternately arranged in the column direction.

Referring to FIG. 16, the first exposure control line TX1 is electrically connected to the control terminals TG (for example, the gates of the transfer transistors 112) of the exposure control circuits 116 in the panchromatic pixels W in the (2n-1)-th row and the 2n-th row. The exposure control line TX2 is electrically connected to the control terminals TG (for example, the gates of the transfer transistors 112) of the exposure control circuits 116 in the color pixels in the (2n-1)-th row and the 2n-th row, where n is a natural number greater than or equal to 1.

For example, when n=1, the first exposure control line TX1 is electrically connected to the control terminals TG of the exposure control circuits 116 in the panchromatic pixels W in the first row and the second row, and the second exposure control line TX2 is electrically connected to the control terminals TG of the exposure control circuits 116 in the color pixels in the first row and the second row. When n=2, the first exposure control line TX1 is electrically connected to the control terminals TG of the exposure control circuits 116 in the panchromatic pixels W in the third and fourth rows, and the second exposure control line TX2 is electrically connected to the control terminals TG of the exposure control circuits 116 in the color pixels in the third and fourth rows, and so on. Further details will be omitted here.

In some embodiments, the first exposure time may be shorter than the second exposure time. The first exposure time may depend on the n-potential well layer 1172 (shown in FIG. 4A) of the panchromatic pixel, and the second exposure time may depend on the n-potential well layer 1172 (shown in FIG. 4A) of the color pixel.

Referring to FIG. 33, the present disclosure provides a camera assembly 40. The camera assembly 40 includes the image sensor 10 described in any one of the above embodiments, a processing chip 20, and a lens 30. The image sensor 10 is electrically connected to the processing chip 20. The lens 30 is provided on the optical path of the image sensor 10. The processing chip 20 may be packaged along with the image sensor 10 and the lens 30 in the same housing of the camera assembly 40. Alternatively, the image sensor 10 and the lens 30 may be packaged in the housing and the processing chip 20 may be arranged outside the housing.

The present disclosure also provides an image capturing method that can be applied in the camera assembly 40 of FIG. 33. As shown in FIG. 34, the image capturing method includes:
01: controlling a two-dimensional pixel array to be exposed to obtain an original panchromatic image and an original color image;
02: processing the original color image to determine all pixels in each subunit as a large monochromatic pixel corresponding to a single color in the subunit, and outputting pixel values of large monochromatic pixels to obtain an intermediate color image;
03: processing the original panchromatic image to obtain an intermediate panchromatic image; and
04: processing the intermediate color image and/or the intermediate panchromatic image to obtain a target image.

Referring to FIG. 2 and FIG. 33, the image capturing method of the present disclosure can be implemented by the camera assembly 40. Here, the step 01 can be implemented by the image sensor 10, and the steps 02, 03, and 04 can be implemented by the processing chip 20. In other words, the image sensor 10 can be configured to be exposed to obtain an original panchromatic image and an original color image. The processing chip 20 can be configured to process the original color image to determine all pixels in each subunit as a large monochromatic pixel corresponding to a single color in the subunit, and output pixel values of the large monochromatic pixels to obtain an intermediate color image. The processing chip 20 can be further configured to process the original panchromatic image to obtain an intermediate panchromatic image; and process the intermediate color image and/or the intermediate panchromatic image to obtain a target image.

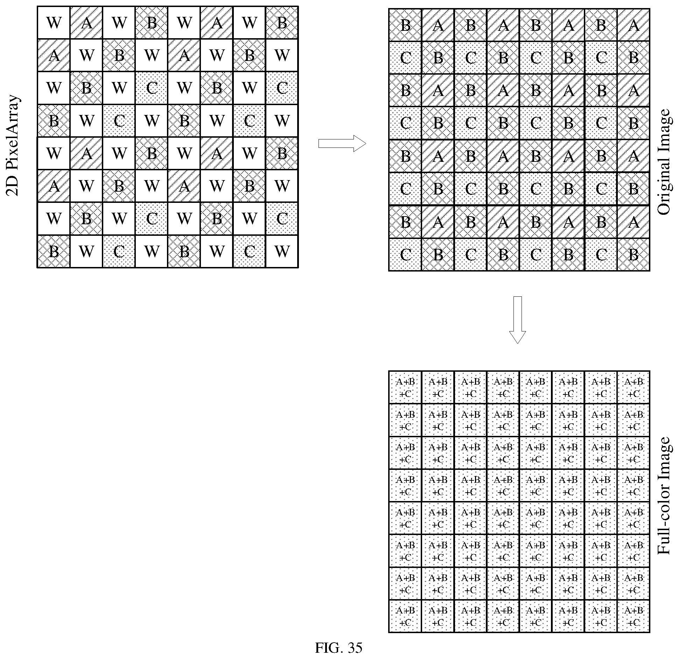

Referring to FIG. 35, in the related art, if the pixel array of the image sensor includes both panchromatic pixels and color pixels, when the image sensor is operating, the image sensor will fit the pixel value of each panchromatic pixel in the pixel array into the pixel values of other color pixels, so as to output an original image including only the color pixels. Specifically, taking pixel A as a red pixel R, pixel B as a green pixel G, and pixel C as a blue pixel Bu as an example, after the column processing unit in the image sensor reads out the pixel values of a plurality of red pixels R, pixel values of a plurality of green pixels G, pixel values of a plurality of blue pixels Bu, and pixel values of a plurality of panchromatic pixels W, the image sensor will first fit the pixel value of each panchromatic pixel W into the red pixel R, green pixel G, and blue pixel Bu adjacent to the panchromatic pixel, and then convert an image arranged in a non-Bayer array into an original image arranged in a Bayer array for outputting, such that the processing chip can perform subsequent processing on the original image, such as interpolating the original image to obtain a full-color image (the pixel value of each pixel in the full-color image is composed of three components of red, green and blue), etc. In this processing scheme, the image sensor needs to execute a complicated algorithm, and the amount of calculation may be relatively large, and since the Qualcomm platform does not support processing of images arranged in non-Bayer arrays, additional hardware (such as an additional processing chip) may be required in the image sensor to perform the process of converting an image arranged in a non-Bayer array into an original image arranged in a Bayer array.

The image capturing method and the camera assembly 40 of the present disclosure can reduce the amount of calculation for the image sensor and avoid adding additional hardware to the image sensor.

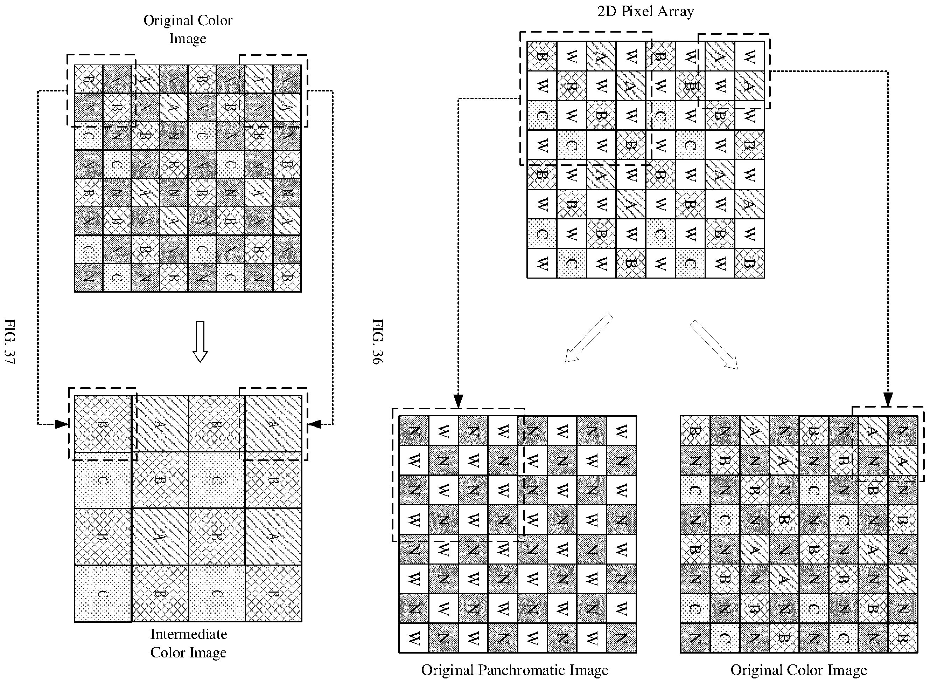

Specifically, referring to FIGS. 2 and 36, when the user requests to take a photo, the vertical driving unit 12 in the image sensor 10 controls a plurality of panchromatic pixels and a plurality of color pixels in the two-dimensional pixel array to be exposed. The column processing unit 14 reads the pixel value of each panchromatic pixel and the pixel value of each color pixel. Instead of performing an operation of fitting the pixel values of the panchromatic pixels into the pixel values of the color pixels, the image sensor 10 directly outputs an original panchromatic image based on the pixel values of the plurality of panchromatic pixels, and directly outputs an original color image based on the pixel values of the plurality of color pixels.

As shown in FIG. 36, the original panchromatic image includes a plurality of panchromatic pixels W and a plurality of null pixels N. The null pixels are neither panchromatic pixels nor color pixels. The position of each null pixel N in the original panchromatic image can be regarded as no pixel at that position, or the pixel value of a null pixel can be regarded as zero. It can be seen from comparison between the two-dimensional pixel array and the original panchromatic image that, for each subunit in the two-dimensional pixel array, the subunit includes two panchromatic pixels W and two color pixels (color pixel A, color pixel B, or color pixel C). The original panchromatic image also has a subunit corresponding to each subunit in the two-dimensional pixel array. The subunit in the original panchromatic image includes two panchromatic pixels W and two null pixels N, and the positions of two null pixels N correspond to the positions of the two color pixels in the subunit of the two-dimensional pixel array.

Similarly, the original color image includes a plurality of color pixels and a plurality of null pixels N. The null pixels are neither panchromatic pixels nor color pixels. The position of each null pixel N in the original color image can be regarded as no pixel at that position, or the pixel value of a null pixel can be regarded as zero. It can be seen from comparison between the two-dimensional pixel array and the original color image that, for each subunit in the two-dimensional pixel array, the subunit includes two panchromatic pixels W and two color pixels. The original color image also has a subunit corresponding to each subunit in the two-dimensional pixel array. The subunit of the original color image includes two color pixels and two null pixels N, and the positions of the two null pixels N correspond to the positions of the two panchromatic pixels W in the subunit of the two-dimensional pixel array.

After the processing chip 20 receives the original panchromatic image and the original color image outputted by the image sensor 10, it can further process the original panchromatic image to obtain an intermediate panchromatic image, and further process the original color image to obtain an intermediate color image. For example, the original color image can be transformed into an intermediate color image in the manner shown in FIG. 37. As shown in FIG. 37, the original color image includes a plurality of subunits, and each subunit includes a plurality of null pixels N and a plurality of color pixels with a single color (also referred to as monochromatic pixels). Specifically, some subunits may each include two null pixels N and two monochromatic pixels A, some subunits may each include two null pixels N and two monochromatic pixels B, and some subunits may each include two null pixels N and two monochromatic pixels C. The processing chip 20 may regard all pixels in the subunit including the null pixels N and the monochromatic pixels A as a large monochromatic pixel A corresponding to the single color A in the subunit, regard all the pixels in the subunit including the null pixels N and the monochromatic pixels B as a large monochromatic pixels B corresponding to the single color B in the subunit, and regard all the pixels in the subunit including the null pixels N and the monochromatic pixels C as a large monochromatic pixel C corresponding to the single color C in the subunit. Thus, the processing chip 20 can form an intermediate color image based on a plurality of large monochromatic pixels A, a plurality of large monochromatic pixels B, and a plurality of large monochromatic pixels C. If the original color image including a plurality of null pixels N is regarded as an image having a second resolution, the intermediate color image obtained in the manner shown in FIG. 37 will be an image having a first resolution lower than the second resolution. After the processing chip 20 obtains the intermediate panchromatic image and the intermediate color image, the intermediate panchromatic image and/or the intermediate color image may be further processed to obtain the target image. Specifically, the processing chip 20 may only process the intermediate panchromatic image to obtain the target image, or the processing chip 20 may alternatively only process the intermediate color image to obtain the target image. Alternatively, the processing chip 20 may process both the intermediate panchromatic image and the intermediate color image to obtain the target image. The processing chip 20 can determine the processing scheme for the two intermediate images according to actual requirements.

In the image capturing method of the embodiment of the present disclosure, the image sensor 10 can directly output the original panchromatic image and the original color image. The subsequent processing of the original panchromatic image and the original color image can be performed by the processing chip 20, and the image sensor 10 does not need to perform the operation of fitting the pixel value of the panchromatic pixel W into the pixel value of the color pixel, thereby reducing the computational complexity of the image sensor 10. Further, there is no need to add new hardware to the image sensor 10 to enable the image sensor 10 to perform image processing, such that the design of the image sensor 10 can be simplified.

In some embodiments, the step 01 of controlling the two-dimensional pixel array to be exposed to obtain the original panchromatic image and the original color image can be implemented in various ways.

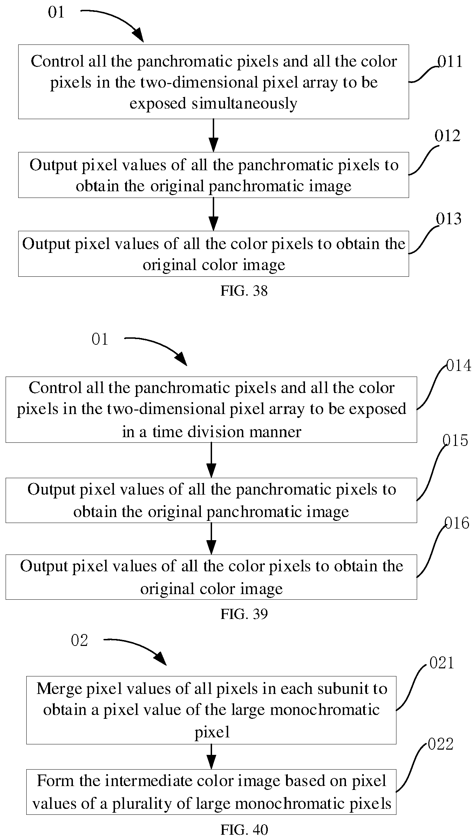

Referring to FIG. 38, in an example, the step 01 may include:
011: controlling all the panchromatic pixels and all the color pixels in the two-dimensional pixel array to be exposed simultaneously;
012: outputting pixel values of all the panchromatic pixels to obtain the original panchromatic image; and
013: outputting pixel values of all the color pixels to obtain the original color image.

Referring to FIG. 33, the steps 011, 012, and 013 can all be implemented by the image sensor 10. In other words, all the panchromatic pixels and all the color pixels in the image sensor 10 can be exposed simultaneously. The image sensor 10 may output pixel values of all the panchromatic pixels to obtain the original panchromatic image, and may also output pixel values of all color pixels to obtain the original color image.

Referring to FIGS. 2 and 16, the panchromatic pixels and the color pixels can be exposed simultaneously. The exposure time of the panchromatic pixels can be shorter than or equal to the exposure time of the color pixels. Specifically, when the first exposure time of the panchromatic pixel is equal to the second exposure time of the color pixel, the exposure start time and the exposure stop time of the panchromatic pixel may be the same as the exposure start time and the exposure stop time of the color pixel, respectively. When the first exposure time is shorter than the second exposure time, the exposure start time of the panchromatic pixel may be later than or equal to the exposure start time of the color pixel, and the exposure stop time of the panchromatic pixel may be earlier than the exposure stop time of the color pixel. Alternatively, when the first exposure time is shorter than the second exposure time, the exposure start time of the panchromatic pixel may be later than the exposure start time of the color pixel, and the exposure stop time of the panchromatic pixel may be earlier than or equal to the exposure stop time of the color pixel. After the panchromatic pixels and the color pixels have been exposed, the image sensor 10 can output the pixel values of all the panchromatic pixels to obtain the original panchromatic image, and output the pixel values of all the color pixels to obtain the original color image. Here, the original panchromatic image can be outputted before the original color image, or the original color image can be outputted before the original panchromatic image, or the original panchromatic image and the original color image can be outputted at the same time. The present disclosure is not limited to any outputting order of these two images. Simultaneous exposure of the panchromatic pixels and the color pixels can reduce the time for obtaining the original panchromatic image and the original color image, and speed up the process of obtaining the original panchromatic image and the original color image. The scheme of simultaneous exposure of the panchromatic pixels and the color pixels has great advantages in fast capturing, continuous capturing, and other modes that require a higher output speed.

Referring to FIG. 39, in another example, the step 01 may include:
014: controlling all the panchromatic pixels and all the color pixels in the two-dimensional pixel array to be exposed in a time division manner;
015: outputting pixel values of all the panchromatic pixels to obtain the original panchromatic image; and
016: outputting pixel values of all the color pixels to obtain the original color image.

Referring to FIG. 33, the steps 014, 015, and 016 can all be implemented by the image sensor 10. In other words, all the panchromatic pixels and all the color pixels in the image sensor 10 can be exposed in a time division manner. The image sensor 10 may output pixel values of all the panchromatic pixels to obtain the original panchromatic image, and may also output pixel values of all color pixels to obtain the original color image.

Specifically, the panchromatic pixels and the color pixels may be exposed in a time division manner. Here, the exposure time of the panchromatic pixels may be shorter than or equal to the exposure time of the color pixels. Specifically, regardless of whether the first exposure time is equal to the second exposure time, all the panchromatic pixels and all the color pixels may be exposed in a time division manner as follows: (1) all the panchromatic pixels are exposed for the first exposure time first, and all the color pixels are exposed for the second exposure time after all the panchromatic pixels have been exposed; or (2) all the color pixels are exposed for the second exposure time first, and all the panchromatic pixels are exposed for the first exposure time after all the color pixels have been exposed. After the panchromatic pixels and the color pixels have been exposed, the image sensor 10 can output the pixel values of all the panchromatic pixels to obtain the original panchromatic image, and output the pixel values of all the color pixels to obtain the original color image. Here, the outputting scheme of the original panchromatic image and the original color image may be as follows: (1) when the panchromatic pixels are exposed before the color pixels, the image sensor 10 can output the original panchromatic image while the color pixels are being exposed, or output the original panchromatic image and the original color image sequentially after the color pixels have been exposed; (2) when the color pixels are exposed before the panchromatic pixels, the image sensor 10 can output the original color image while the panchromatic pixels are being exposed, or output the original color image and the original panchromatic image sequentially after the panchromatic pixels have been exposed; or (3) no matter which of the panchromatic pixels and the color pixels are exposed first, the image sensor 10 can output the original panchromatic image and the original color image at the same time after all the pixels have been exposed. In this example, the control logic of the time-division exposure of the panchromatic pixels and the color pixels is relatively simple.

The image sensor 10 may have both the functions of controlling the panchromatic pixels and the color pixels to be exposed simultaneously and controlling the panchromatic pixels and the color pixels to be exposed in a time-division manner, as shown in FIGS. 38 and 39, respectively. The specific exposure scheme to be used by the image sensor 10 in the process of capturing images can be selected according to actual requirements. For example, simultaneous exposure can be used in fast capturing, continuous capturing and other modes to meet the need of rapid image output. In an ordinary capturing mode, the time-division exposure can be used to simplify the control logic.

In the two examples shown in FIGS. 38 and 39, the exposure sequence of the panchromatic pixels and the color pixels can be controlled by the control unit 13 in the image sensor 10.

In the two examples shown in FIGS. 38 and 39, the exposure time of the panchromatic pixels can be controlled by the first exposure signal, and the exposure time of the color pixels can be controlled by the second exposure signal.

Specifically, referring to FIG. 16, as an example, the image sensor 10 may use the first exposure signal to control at least two adjacent panchromatic pixels in the first diagonal direction to be exposed for the first exposure time, and use the second exposure signal to control at least two adjacent color pixels in the second diagonal direction to be exposed for second exposure time. The first exposure time may be shorter than or equal to the second exposure time. Specifically, the vertical driving unit 12 in the image sensor 10 can transmit the first exposure signal through the first exposure control line TX1 to control at least two adjacent panchromatic pixels in the first diagonal direction to be exposed for the first exposure time. The vertical driving unit 12 can transmit the second exposure signal through the second exposure control line TX2 to control at least two adjacent panchromatic pixels in the second diagonal direction to be exposed for the second exposure time. After all the panchromatic pixels and all the color pixels have been exposed, as shown in FIG. 36, instead of performing the process of fitting pixel values of a plurality of panchromatic pixels into the pixel values of the color pixels, the image sensor 10 can directly output one original panchromatic image and one original color image.

Referring to FIG. 2 and FIG. 17, as another example, the image sensor 10 may use the first exposure signal to control the panchromatic pixels in the (2n-1)-th row and the 2n-th row to be exposed for the first exposure time, and use the second exposure signal to control the color pixels in the (2n-1)-th row and the 2n-th row to be exposed for the second exposure time. Here, the first exposure time may be shorter than or equal to the second exposure time. Specifically, the first exposure control line TX1 in the image sensor 10 is connected to the control terminals TG of all the panchromatic pixels in the (2n-1)-th row and the 2n-th row, and the second exposure control line TX2 is connected the control terminals TG of all the color pixels in the (2n-1)-th row and the 2n-th row. The vertical driving unit 12 transmits the first exposure signal through the first exposure control line TX1 to control the panchromatic pixels in the (2n-1)-th row and the 2n-th row to be exposed for the first exposure time, and transmits the second exposure signal through the second exposure control line TX2 to control the color pixels in the (2n-1)-th row and the 2n-th row to be exposed for the second exposure time. After all the panchromatic pixels and all the color pixels have been exposed, as shown in FIG. 36, instead of performing the process of fitting pixel values of a plurality of panchromatic pixels into the pixel values of the color pixels, the image sensor 10 directly outputs one original panchromatic image and one original color image.

In some embodiments, the processing chip 20 may determine the relative relation between the first exposure time and the second exposure time based on ambient brightness. For example, the image sensor 10 may control the panchromatic pixels to be exposed first and output an original panchromatic image, and the processing chip 20 may analyze the pixel values of a plurality of panchromatic pixels in the original panchromatic image to determine the ambient brightness. When the ambient brightness is smaller than or equal to a brightness threshold, the image sensor 10 may control the panchromatic pixels to be exposed for the first exposure time that is equal to the second exposure time. When the ambient brightness is greater than the brightness threshold, the image sensor 10 may control the panchromatic pixels to be exposed for the first exposure time that is smaller than the second exposure time. When the ambient brightness is greater than the brightness threshold, the relative relation between the first exposure time and the second exposure time can be determined based on a brightness difference between the ambient brightness and the brightness threshold. For example, the greater the brightness difference, the smaller the ratio of the second exposure time to the first exposure time. For example, when the brightness difference is within a first range [a,b), the ratio of the first exposure time to the second exposure time may be V1:V2, when the brightness difference is within a second range [b,c), the ratio of the first exposure time to the second exposure time may be V1:V3, and when the brightness difference is greater than or equal to c, the ratio of the first exposure time to the second exposure time may be V1:V4, where V1<V2<V3< V4.

Referring to FIG. 40, in some embodiments, the step 02 may include:
021: combining pixel values of all pixels in each subunit to obtain a pixel value of the large monochromatic pixel; and
022: forming the intermediate color image based on pixel values of a plurality of large monochromatic pixels, the intermediate color image having a first resolution.

Referring to FIG. 33, in some embodiments, both the step 021 and the step 022 can be implemented by the processing chip 20. In other words, the processing chip 20 can be configured to merge pixel values of all pixels in each subunit to obtain the pixel value of the large monochromatic pixel, and form the intermediate color image based on pixel values of a plurality of large monochromatic pixels. Here, the intermediate color image has a first resolution.

Specifically, as shown in FIG. 37, for a large monochromatic pixel A, the processing chip 20 may add the pixel values of all pixels in the subunit including the null pixels N and the monochromatic pixels A, and use the result of the addition as the pixel value of the large monochromatic pixel A of the corresponding subunit. Here, the pixel value of each null pixel N can be regarded as zero (the same also applies below). The processing chip 20 may add the pixel values of all pixels in the subunit including the null pixels N and the monochromatic pixels B, and use the result of the addition as the pixel value of the large monochromatic pixel B of the corresponding subunit. The processing chip 20 may add the pixel values of all pixels in the subunit, including the null pixels N and the monochromatic pixels C, and use the result of the addition as the pixel value of the large monochromatic pixel C of the corresponding subunit. Thus, the processing chip 20 can obtain the pixel values of a plurality of large monochromatic pixels A, the pixel values of a plurality of large monochromatic pixels B, and the pixel values of a plurality of large monochromatic pixels C. The processing chip 20 can then form the intermediate color image based on the pixel values of the plurality of large monochromatic pixels A, the pixel values of the plurality of large monochromatic pixels B, and the pixel values of the plurality of large monochromatic pixels C. As shown in FIG. 37, when the single color A is red R, the single color B is green G, and the single color C is blue Bu, the intermediate color image is an image arranged in a Bayer array. Of course, the scheme in which the processing chip 20 obtains the intermediate color image is not limited to this example.

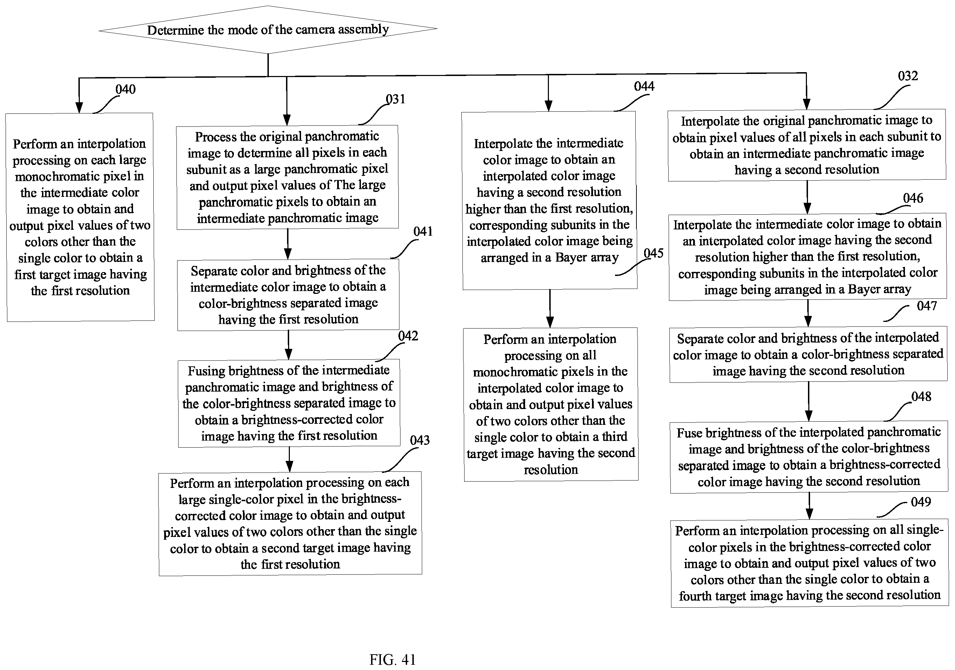

In some embodiments, referring to FIGS. 33 and 41, when the camera assembly 40 is in different modes, the different modes correspond to different target images. The processing chip 20 may first determine which mode the camera assembly 40 is in, and then perform a corresponding processing on the intermediate color image and/or the intermediate panchromatic image in accordance with the mode of the camera assembly 40, so as to obtain the target image corresponding to the mode. The target image may include at least four types of target images: a first target image, a second target image, a third target image, and a fourth target image. The modes of the camera assembly 40 may include at least: (1) a preview mode, in which the target image can be the first target image or the second target image; (2) an imaging mode, in which the target image can be the second target image, the third target image, or the fourth target image; (3) a preview mode plus a low power consumption mode, in which the target image may be the first target image; (4) a preview mode plus a non-low power consumption mode, in which the target image may be the second target image; (5) an imaging mode plus a low power consumption mode, in which the target image may be the second target image or the third target image; and (6) an imaging mode plus a non-low power consumption mode, in which the target image may be the fourth target image.

Referring to FIG. 41, in an example, when the target image is the first target image, the step 04 may include:
040: performing an interpolation processing on each large monochromatic pixel in the intermediate color image to obtain and output pixel values of two colors other than the single color to obtain a first target image having the first resolution.

Referring to FIG. 33, the step 040 can be implemented by the processing chip 20. In other words, the processing chip 20 can be configured to perform an interpolation processing on each large monochromatic pixel in the intermediate color image to obtain and output pixel values of two colors other than the single color to obtain a first target image having the first resolution.

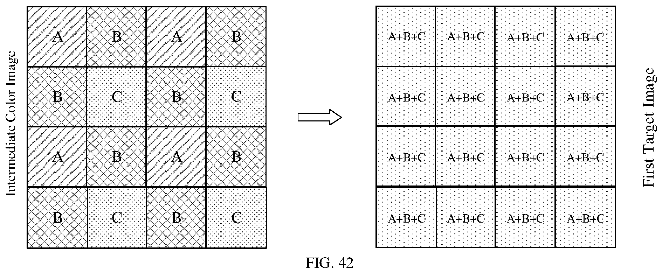

Specifically, referring to FIG. 42, assuming that the large monochromatic pixel A is the red pixel R, the large monochromatic pixel B is the green pixel G, and the large monochromatic pixel C is the blue pixel Bu, the intermediate color image is an image arranged in a Bayer array. The processing chip 20 needs to perform a demosaicing (that is, interpolation) processing on the intermediate color image, such that the pixel value of each large monochromatic pixel has all three components of R, G, and B. For example, a linear interpolation method may be used to calculate the pixel values of the two colors for each large monochromatic pixel other than the single color of the large monochromatic pixel. Take the large monochromatic pixel C2,2 ("C2,2" means the pixel C in the second row and the second column from the upper left) as an example, the large monochromatic pixel C2,2 only has the pixel value P(C2,2) of the component of color C, it is also needed to calculate the pixel value P(A2,2) of color A and the pixel value P(B2,2) of color B at the position of the large monochromatic pixel C, then P(A_{2,2})=α₁ •P(A_{3,1})+ α₂•P(A_{3,3})+α₃•P(A_{1,3})+α₄•P(A_{1,1}), P(B_{2,2})= β₁•P(B_{1,2}) + β₂•P(B_{2,1})+ β₃•P(B_{2,3})+β₄•P(B_{3,2}), where α1 to α4 and β1 to β4 are interpolation coefficients, and α₁+ α₂+α₃+ α₄=1, β₁+ β₂+β₃+ β₄=1. The above scheme for calculation of P(A_{2,2}) and P(B2,2) is an example only, and P(A2,2) and P(B2,2) can also be calculated using other interpolation methods than linear interpolation. The present disclosure is not limited to any of these examples.

After the processing chip 20 calculates the pixel values of the three components of each large monochromatic pixel, it can calculate a final pixel value corresponding to the large monochromatic pixel based on the three pixel values, that is, A+B+C. It is to be noted that A+B+C here does not mean that the final pixel value of the large monochromatic pixel is obtained by directly adding the three pixels, but only means that the large monochromatic pixel includes the three color components of A, B, and C. The processing chip 20 may form the first target image based on the final pixel values of a plurality of large monochromatic pixels. Since the intermediate color image has the first resolution, the first target image is obtained by performing the interpolation processing on the intermediate color image, and the processing chip 20 does not interpolate the intermediate color image, the resolution of the first target image is also the first resolution. The processing algorithm used by the processing chip 20 to process the intermediate color image to obtain the first target image is relatively simple, and the processing speed is relatively high. When the camera assembly 40 uses the first target image as a preview image when its mode is the preview mode plus the low power consumption mode, the requirement on the image output speed in the preview mode can be met, and the power consumption of the camera assembly 40 can also be saved.

Referring to FIG. 41 again, in another example, when the target image is the second target image, the step 03 may include:
031: processing the original panchromatic image to determine all pixels in each subunit as a large panchromatic pixel and outputting pixel values of the large panchromatic pixels to obtain an intermediate panchromatic image, the intermediate panchromatic image having the first resolution.

The step 04 may include:
041: separating color and brightness of the intermediate color image to obtain a color-brightness separated image having the first resolution;
042: fusing brightness of the intermediate panchromatic image and brightness of the color-brightness separated image to obtain a brightness-corrected color image having the first resolution; and
043: performing an interpolation processing on each large monochromatic pixel in the brightness-corrected color image to obtain and output pixel values of two colors other than the single color to obtain a second target image having the first resolution.

Referring to FIG. 33, the steps 031, step 041, step 042, and step 043 can all be implemented by the processing chip 20. In other words, the processing chip 20 can be configured to process the original panchromatic image to determine all pixels in each subunit as a large panchromatic pixel and output pixel values of the large panchromatic pixels to obtain an intermediate panchromatic image, the intermediate panchromatic image having the first resolution. The processing chip 20 can be further configured to separate color and brightness of the intermediate color image to obtain a color-brightness separated image having the first resolution; fuse brightness of the intermediate panchromatic image and brightness of the color-brightness separated image to obtain a brightness-corrected color image having the first resolution; and perform an interpolation processing on each large monochromatic pixel in the brightness-corrected color image to obtain and output pixel values of two colors other than the single color to obtain a second target image having the first resolution.

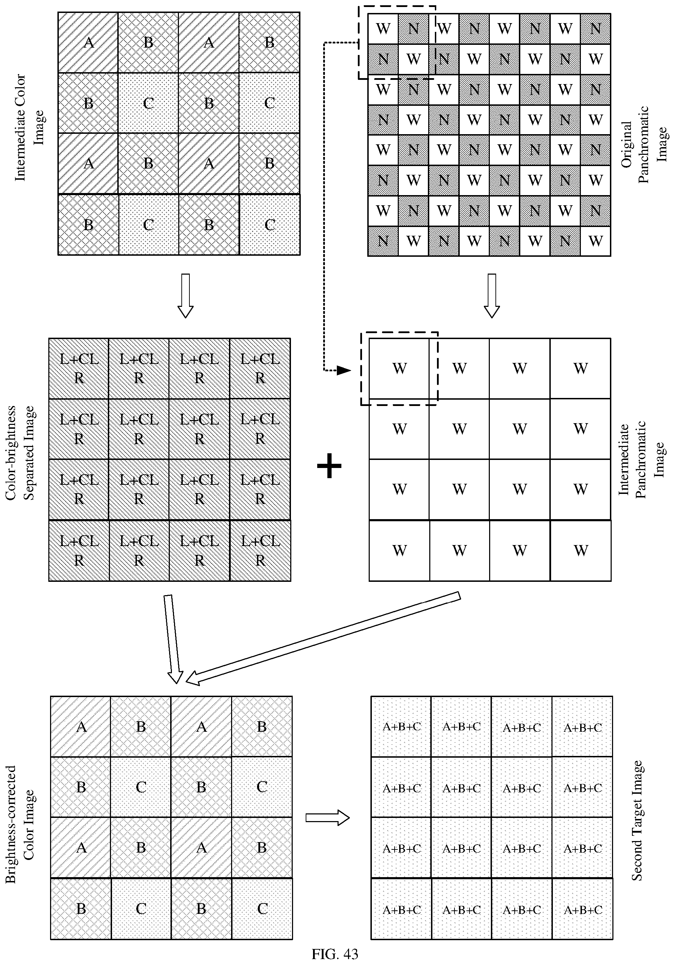

Specifically, the original panchromatic image can be transformed into the intermediate panchromatic image in the manner shown in FIG. 43. As shown in FIG. 43, the original panchromatic image includes a plurality of subunits each including two null pixels N and two panchromatic pixels W. The processing chip 20 may determine all pixels in each subunit including the null pixels N and the panchromatic pixels W as a large panchromatic pixel W corresponding to the subunit. Thus, the processing chip 20 can form an intermediate panchromatic image based on a plurality of large panchromatic pixels W. If the original panchromatic image including a plurality of null pixels N is regarded as an image having the second resolution, the intermediate panchromatic image obtained in the manner shown in FIG. 43 is an image having the first resolution. Here, the first resolution is lower than the second resolution.

As an example, the processing chip 20 may determine all the pixels of each subunit in the original panchromatic image as the large panchromatic pixel W corresponding to the subunit in the following manner. The processing chip 20 can first merge pixel values of all pixels in each subunit to obtain the pixel value of the large panchromatic pixel W, and then form the intermediate panchromatic image based on the pixel values of a plurality of large panchromatic pixels W. Specifically, for each large panchromatic pixel, the processing chip 20 may add all the pixel values in each subunit including the null pixels N and the panchromatic pixels W, and use the result of the addition as the pixel value of the large panchromatic pixel W corresponding to the subunit. The pixel value of each null pixel N can be regarded as zero. In this way, the processing chip 20 can obtain the pixel values of the plurality of large panchromatic pixels W.

After the processing chip 20 obtains the intermediate panchromatic image and the intermediate color image, it can fuse the intermediate panchromatic image and the intermediate color image to obtain a second target image.

For example, as shown in FIG. 43, the processing chip 20 can first separate color and brightness of the intermediate color image to obtain a color-brightness separated image. In the color-brightness separated image in FIG. 43, L represents the brightness, and CLR represents the color. Specifically, assuming that the monochromatic pixel A is a red pixel R, the monochromatic pixel B is a green pixel G, and the monochromatic pixel C is a blue pixel Bu, then: (1) the processing chip 20 can convert the intermediate color image in a RGB space into a color-brightness separated image in a YCrCb space, in which case Y in YCrCb is the brightness L in the color-brightness separated image, and Cr and Cb in YCrCb are the color CLR in the color-brightness separated image; or (2) the processing chip 20 can alternatively convert the intermediate color image in the RGB space into a color-brightness separated image in a Lab space, in which case L in Lab is the brightness L in the color-brightness separated image, and a and b in Lab are the color CLR in the color-brightness separated image. It is to be noted that L+CLR in the color-brightness separated image shown in FIG. 43 does not mean that the pixel value of each pixel is formed by adding L and CLR, but only means that the pixel value of each pixel is composed of L and CLR.

Subsequently, the processing chip 20 can fuse the brightness of the color-brightness separated image and the brightness of the intermediate panchromatic image. For example, the pixel value of each panchromatic pixel W in the intermediate panchromatic image is the brightness value of each panchromatic pixel. The processing chip 20 may add L of each pixel in the color-brightness separated image to W of the panchromatic pixel at the corresponding position in the intermediate panchromatic image, to obtain a brightness-corrected pixel value. The processing chip 20 can form a brightness-corrected color-brightness separated image based on a plurality of brightness-corrected pixel values, and then perform a color space conversion to convert the brightness-corrected color-brightness separated image into a brightness-corrected color image.

When the large monochromatic pixel A is the red pixel R, the large monochromatic pixel B is the green pixel G, and the large monochromatic pixel C is the blue pixel Bu, the brightness-corrected color image is an image arranged in a Bayer array, and the processing chip 20 needs to perform an interpolation processing on the brightness-corrected color image, such that the pixel value of each brightness-corrected large monochromatic pixel has all three components of R, G, and B. The processing chip 20 may perform an interpolation processing on the brightness-corrected color image to obtain the second target image. For example, a linear interpolation method may be used to obtain the second target image. The linear interpolation processing is similar to the interpolation processing in the step 040 as described above and details thereof will be omitted here.

Since the brightness-corrected color image has the first resolution, the second target image is obtained by performing the interpolation processing on the brightness-corrected color image, and the processing chip 20 does not interpolate the brightness-corrected color image, the resolution of the second target image is also the first resolution. Since the second target image is obtained by fusing the brightness of the intermediate color image and the brightness of the intermediate panchromatic image, the second target image has a better imaging effect. When the mode is the preview mode plus the non-low power consumption mode, using the second target image as a preview image can improve the preview effect of the preview image. When the mode is the imaging mode plus the low power consumption mode, the second target image can be used as the image provided to the user. Since the second target image is calculated without any interpolation, the power consumption of the camera assembly 40 can be reduced to a certain extent, which can meet the usage requirement in the low power consumption mode. At the same time, the brightness of the second target image is relatively high, which can meet the user's requirement on brightness for the target image.

Referring to FIG. 41 again, in another example, when the target image is the third target image, the step 04 may include:
044: interpolating the intermediate color image to obtain an interpolated color image having a second resolution higher than the first resolution, corresponding subunits in the interpolated color image being arranged in a Bayer array; and
045: performing an interpolation processing on all monochromatic pixels in the interpolated color image to obtain and output pixel values of two colors other than the single color to obtain a third target image having the second resolution.

Referring to FIG. 33, both the steps 044 and 045 can be implemented by the processing chip 20. In other words, the processing chip 20 can be configured to interpolating the intermediate color image to obtain an interpolated color image having a second resolution higher than the first resolution, corresponding subunits in the interpolated color image being arranged in a Bayer array. The processing chip 20 can be further configured to perform an interpolation processing on all monochromatic pixels in the interpolated color image to obtain and output pixel values of two colors other than the single color to obtain a third target image having the second resolution.

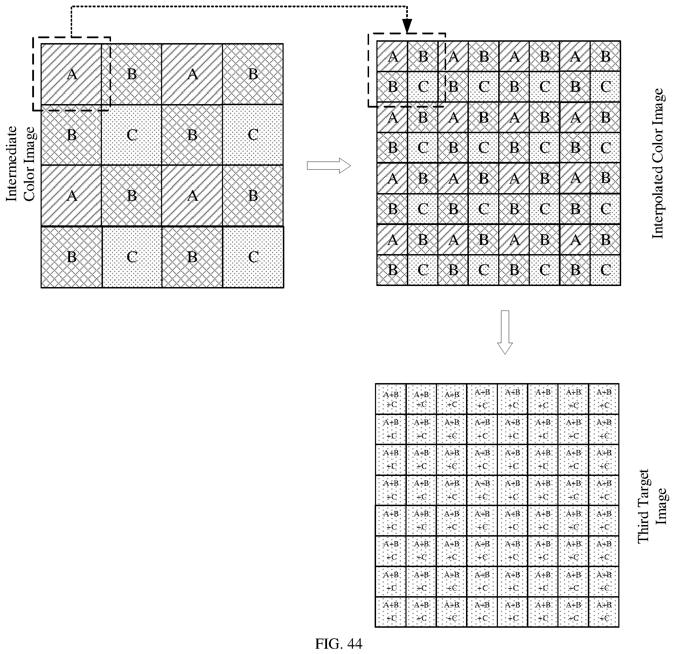

Specifically, referring to FIG. 44, the processing chip 20 can divide each large monochromatic pixel in the intermediate color image into four color pixels. The four color pixels form a subunit in the interpolated color image, and each subunit includes color pixels of three colors, including one color pixel A, two color pixels B, and one color pixel C. When the color pixel A is a red pixel R, the color pixel B is a green pixel G, and the color pixel C is a blue pixel Bu, the plurality of color pixels in each subunit are arranged in a Bayer array. Therefore, the interpolated color image containing a plurality of subunits is an image arranged in a Bayer array. The processing chip 20 may perform an interpolation processing on the interpolated color image to obtain the third target image. For example, a linear interpolation method may be used to obtain the second target image. The linear interpolation processing is similar to the interpolation processing in the step 040 as described above and details thereof will be omitted here. The third target image is an image obtained as a result of the interpolation, and the resolution of the third target image (that is, the second resolution) is higher than the resolution of the intermediate color image (that is, the first resolution). When the mode is the preview mode plus the non-low power consumption mode, the third target image can be used as a preview image to obtain a clearer preview image. When the mode is the imaging mode plus the low power consumption mode, the third target image can be used as the image provided to the user. Since the third target image is formed without being fused with the intermediate panchromatic image in terms of brightness, the power consumption of the camera assembly 40 can be reduced to a certain extent, and the user's requirement on the clarity of the captured image can also be met.

Referring to FIG. 41 again, in another example, when the target image is the fourth target image, the step 03 may include:
032: interpolating the original panchromatic image to obtain pixel values of all pixels in each subunit to obtain an intermediate panchromatic image having a second resolution.

The step 04 may include:
046: interpolating the intermediate color image to obtain an interpolated color image having the second resolution higher than the first resolution, corresponding subunits in the interpolated color image being arranged in a Bayer array;
047: separating color and brightness of the interpolated color image to obtain a color-brightness separated image having the second resolution;
048: fusing brightness of the interpolated panchromatic image and brightness of the color-brightness separated image to obtain a brightness-corrected color image having the second resolution; and
049: performing an interpolation processing on all monochromatic pixels in the brightness-corrected color image to obtain and output pixel values of two colors other than the single color to obtain a fourth target image having the second resolution.

Referring to FIG. 33, the steps 032, 046, 047, 048, and 049 can all be implemented by the processing chip 20. In other words, the processing chip 20 can be configured to interpolate the original panchromatic image to obtain pixel values of all pixels in each subunit to obtain an intermediate panchromatic image having a second resolution. The processing chip 20 can be further configured to interpolate the intermediate color image to obtain an interpolated color image having the second resolution higher than the first resolution, corresponding subunits in the interpolated color image being arranged in a Bayer array. The processing chip 20 can be further configured to separate color and brightness of the interpolated color image to obtain a color-brightness separated image having the second resolution, fuse the brightness of the interpolated panchromatic image and the brightness of the color-brightness separated image to obtain a brightness-corrected color image having the second resolution; and perform an interpolation processing on all monochromatic pixels in the brightness-corrected color image to obtain and output pixel values of two colors other than the single color to obtain a fourth target image having the second resolution.

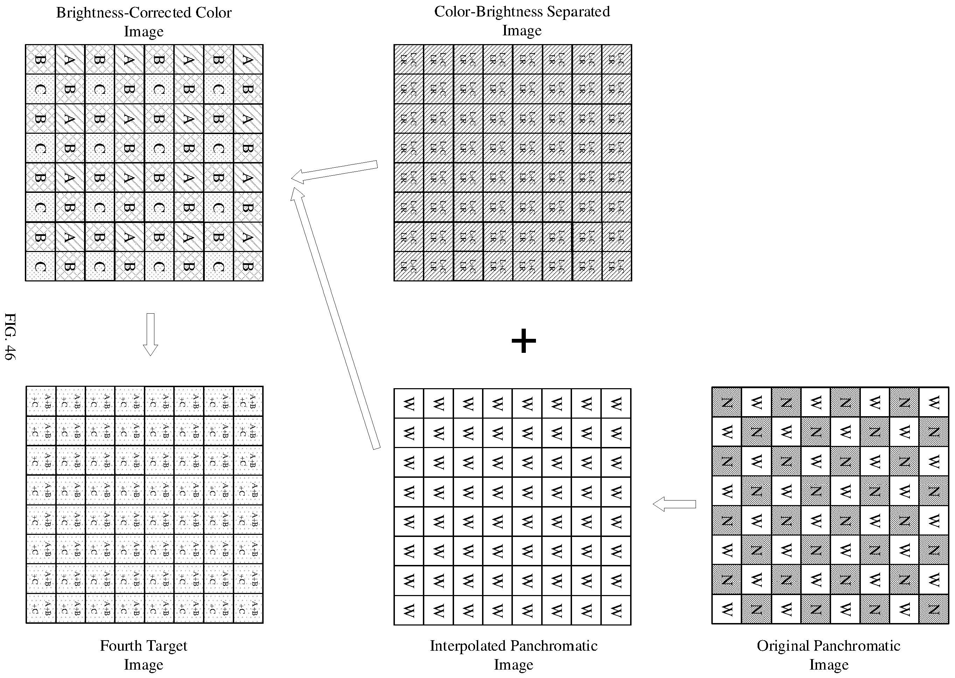

Specifically, the processing chip 20 can first perform an interpolation on the original panchromatic image having the first resolution to obtain the intermediate panchromatic image having the second resolution. Referring to FIG. 46, the original panchromatic image includes a plurality of subunits each including two null pixels N and two panchromatic pixels W. The processing chip 20 needs to replace each null pixel N in each subunit with a panchromatic pixel W, and calculate the pixel value of each panchromatic pixel W at the position of the null pixel N after the replacement. For each null pixel N, the processing chip 20 replaces the null pixel N with a panchromatic pixel W, and determines the pixel value of the panchromatic pixel W after replacement based on the pixel values of other panchromatic pixels W adjacent to the panchromatic pixel W after replacement. Taking the null pixel N_{1, 8} in the original panchromatic image shown in FIG. 46 as an example ("null pixel N_{1, 8}" is the null pixel N in the first row and the eighth column from the upper left, the same applies below), the null pixel N_{1, 8} is replaced with a panchromatic pixel W_{1, 8}, and the pixels adjacent to the panchromatic pixel W_{1, 8} are the panchromatic pixels W_{1, 7} and the panchromatic pixel W_{2, 8} in the original panchromatic image. As an example, the average value of the pixel values of the panchromatic pixel W_{1, 7} and the pixel value of the panchromatic pixel W_{2, 8} may be used as the pixel value of the panchromatic pixel W_{1, 8}. Taking the null pixel N_{2, 3} in the original panchromatic image shown in FIG. 46 as an example, the null pixel N_{2, 3} is replaced with a panchromatic pixel W_{2, 3}, and the panchromatic pixels adjacent to the panchromatic pixel W2,3 are the panchromatic pixel W_{1, 3}, the panchromatic pixel W2,2, the panchromatic pixel W2,4, and the panchromatic pixel W_{3, 3} in the original panchromatic image. As an example, the processing chip 20 can use the average value of the pixel values of the panchromatic pixels W_{1, 3}, W_{2, 2}, W_{2, 4}, and W_{3, 3} as the pixel value of the panchromatic pixel W2,3 after replacement.

After the processing chip 20 obtains the intermediate panchromatic image and the intermediate color image, it can fuse the intermediate panchromatic image and the intermediate color image to obtain the fourth target image.

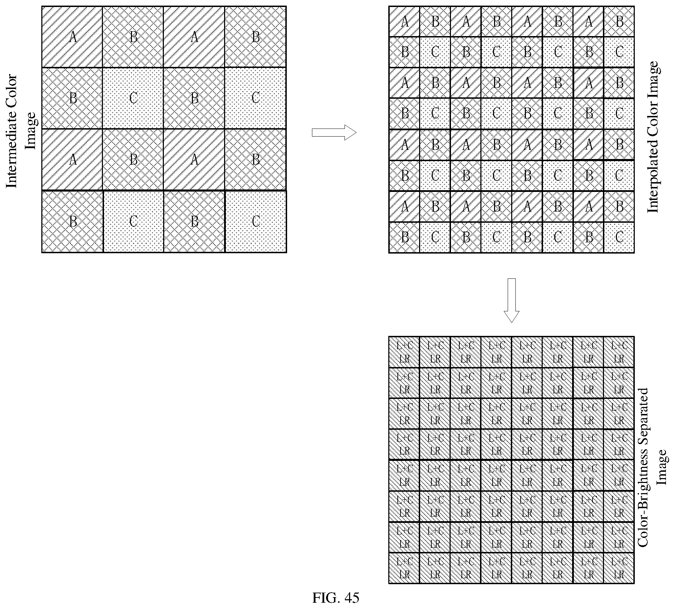

First, the processing chip 20 may interpolate the intermediate color image having the first resolution to obtain the interpolated color image having the second resolution, as shown in FIG. 45. The specific interpolation scheme is similar to the interpolation scheme in the step 045, and details thereof will be omitted here.

Subsequently, as shown in FIG. 45, the processing chip 20 can separate color and brightness of the interpolated color image to obtain a color-brightness separated image. In the color-brightness separated image in FIG. 45, L represents the brightness, and CLR represents the color. Specifically, assuming that the monochromatic pixel A is a red pixel R, the monochromatic pixel B is a green pixel G, and the monochromatic pixel C is a blue pixel Bu, then: (1) the processing chip 20 can convert the interpolated color image in a RGB space into a color-brightness separation image in a YCrCb space, in which case Y in YCrCb is the brightness L in the color-brightness separated image, and Cr and Cb in YCrCb are the color CLR in the color-brightness separated image; or (2) the processing chip 20 can alternatively convert the interpolated color image in the RGB space into a color-brightness separated image in a Lab space, in which case L in Lab is the brightness L in the color-brightness separated image, and a and b in Lab are the color CLR in the color-brightness separated image. It is to be noted that L+CLR in the color-brightness separated image shown in FIG. 45 does not mean that the pixel value of each pixel is formed by adding L and CLR, but only means that the pixel value of each pixel is composed of L and CLR.

Subsequently, as shown in FIG. 46, the processing chip 20 can fuse the brightness of the color-brightness separated image and the brightness of the intermediate panchromatic image. For example, the pixel value of each panchromatic pixel W in the intermediate panchromatic image is the brightness value of each panchromatic pixel. The processing chip 20 may add L of each pixel in the color-brightness separated image to W of the panchromatic pixel at the corresponding position in the intermediate panchromatic image, to obtain a brightness-corrected pixel value. The processing chip 20 can form a brightness-corrected color-brightness separated image based on a plurality of brightness-corrected pixel values, and then perform a color space conversion to convert the brightness-corrected color-brightness separated image into a brightness-corrected color image. The brightness-corrected color image has the second resolution.

When the color pixel A is a red pixel R, the color pixel B is a green pixel G, and the color pixel C is a blue pixel Bu, the brightness-corrected color image is an image arranged in a Bayer array, and the processing chip 20 needs to perform an interpolation processing on the brightness-corrected color image, such that the pixel value of each brightness-corrected color pixel has all three components of R, G, and B. The processing chip 20 may perform an interpolation processing on the brightness-corrected color image to obtain the fourth target image. For example, a linear interpolation method may be used to obtain the fourth target image. The linear interpolation processing is similar to the interpolation processing in the step 040 as described above and details thereof will be omitted here.

Since the fourth target image is obtained by fusing the brightness of the intermediate color image and the brightness of the intermediate panchromatic image, and the fourth target image has a higher resolution, the fourth target image has better brightness and clarity. When the mode is the imaging mode plus the non-low power consumption mode, using the fourth target image as the image provided to the user can meet the user's requirement on the quality of the captured image.

In some embodiments, the image capturing method may further include obtaining ambient brightness. This step can be implemented by the processing chip 20, and the specific implementation has been described above, and details thereof will be omitted here. When the ambient brightness is greater than a brightness threshold, the first target image or the third target image may be used as the target image. When the ambient brightness is smaller than or equal to the brightness threshold, the second target image or the fourth target image may be used as the target image. It can be appreciated that when the ambient brightness is relatively high, the brightness of the first target image and the second target image obtained from the intermediate color image only is sufficient to meet the user's requirement on the brightness of the target image, and there is no need to fuse the brightness of the intermediate panchromatic image to increase the brightness of the target image. In this way, not only can the calculation amount of the processing chip 20 be reduced, but also the power consumption of the camera assembly 40 can be reduced. When the ambient brightness is relatively low, the brightness of the first target image and the second target image obtained from the intermediate color image only may not meet the user's requirement on the brightness of the target image, and the second target image or the fourth target image obtained by fusing the brightness of the intermediate panchromatic image can be used as the target image, which can increase the brightness of the target image.

Referring to FIG. 47, the present disclosure also provides a mobile terminal 90. The mobile terminal 90 may be a mobile phone, a tablet computer, a notebook computer, a smart wearable device (such as a smart watch, a smart bracelet, a pair of smart glasses, a smart helmet, etc.), a head-mounted display device, a virtual reality device, etc., and the present disclosure is not limited to any of these examples.

The mobile terminal 90 includes an image sensor 50, a processor 60, a memory 70, and a housing 80. The image sensor 50, the processor 60, and the memory 70 are all mounted in the housing 80. Here, the image sensor 50 is connected to the processor 60, and the image sensor 50 may be the image sensor 10 (shown in FIG. 33) described in any one of the above embodiments. The processor 60 can perform the same functions as the processing chip 20 in the camera assembly 40 (shown in FIG. 33). In other words, the processor 60 can implement the functions that can be implemented by the processing chip 20 as described in any of the above embodiments. The memory 70 is connected to the processor 60, and the memory 70 can store data obtained as a result of processing by the processor 60, such as the target image. The processor 60 and the image sensor 50 may be mounted on a same substrate. At this time, the image sensor 50 and the processor 60 can be regarded as a camera assembly 40. Of course, the processor 60 and the image sensor 50 may alternatively be mounted on different substrates.

The image sensor 50 in the mobile terminal 90 of the present disclosure is provided with a condenser lens 1186 to condense light, such that more light can enter the photoelectric conversion element 117 of the corresponding pixel, thereby avoiding the problem of optical cross interference between adjacent pixels, and improving the imaging quality of the image sensor 50.

In the present disclosure, the description with reference to the terms "one embodiment", "some embodiments", "exemplary embodiments", "an example", "a specific example", or "some examples", etc., means that specific features, structures, materials, or characteristics described in conjunction with the embodiment(s) or example(s) are included in at least one embodiment or example of the present disclosure. In the present disclosure, any illustrative reference of the above terms does not necessarily refer to the same embodiment(s) or example(s). Moreover, the specific features, structures, materials or characteristics as described can be combined in any one or more embodiments or examples as appropriate. In addition, those skilled in the art can combine and integrate different embodiments or examples, or features thereof, as described in the present disclosure, provided that they do not contradict each other.

Any process or method described in the flowchart or described otherwise herein can be understood as a module, segment or part of codes that include one or more executable instructions for implementing steps of specific logical functions or processes. It can be appreciated by those skilled in the art that the scope of the preferred embodiments of the present disclosure includes additional implementations where functions may not be performed in the order as shown or discussed, including implementations where the involved functions are performed substantially in parallel or even in a reverse order.

Although the embodiments of the present disclosure have been shown and described above, it can be appreciated that the above embodiments are exemplary only, and should not be construed as limiting the present disclosure. Various changes, modifications, replacements and variants can be made to the above embodiments by those skilled in the art without departing from the scope of the present disclosure.

## Claims

1. An image sensor, comprising a plurality of pixels, wherein at least some of the plurality of pixels each comprise:
an isolation layer;
a condenser lens provided within the isolation layer; and
a photoelectric conversion element configured to receive light passing through the condenser lens.

2. The image sensor according to claim 1, wherein
the plurality of pixels comprise a plurality of panchromatic pixels and a plurality of color pixels, each of the plurality of color pixels comprising the isolation layer, the condenser lens, and the photoelectric conversion element; or
the plurality of pixels comprise a plurality of panchromatic pixels and a plurality of color pixels, each of the plurality of panchromatic pixels comprising the isolation layer, the condenser lens, and the photoelectric conversion element, and each of the plurality of color pixels comprising the isolation layer, the condenser lens, and the photoelectric conversion element.

3. The image sensor according to claim 1, wherein an anti-reflection film is provided on a side of the condenser lens that faces towards the photoelectric conversion element.

4. The image sensor according to claim 1, further comprising an optical isolation interlayer that is provided between the isolation layers of two adjacent pixels.

5. The image sensor according to claim 1, wherein the plurality of pixels comprise a plurality of panchromatic pixels and a plurality of color pixels, each color pixel having a narrower spectral response than each panchromatic pixel, and each panchromatic pixel having a higher full well capacity than each color pixel.

6. The image sensor according to claim 5, wherein each of the plurality of pixels comprises a photoelectric conversion element, and each photoelectric conversion element comprises a substrate and an n-potential well layer formed within the substrate.

7. The image sensor according to claim 6, wherein a size of a cross section of the n-potential well layer of each panchromatic pixel is equal to a size of a cross section of the n-potential well layer of each color pixel, and a depth of the n-potential well layer of each panchromatic pixel is greater than a depth of the n-potential well layer of each color pixel.

8. The image sensor according to claim 6, wherein a size of a cross section of the n-potential well layer of each panchromatic pixel is greater than a size of a cross section of the n-potential well layer of each color pixel, and a depth of the n-potential well layer of each panchromatic pixel is greater than or equal to a depth of the n-potential well layer of each color pixel.

9. The image sensor according to claim 8, wherein sizes of the cross sections of the n-potential well layer of each pixel are equal in a light-receiving direction of the image sensor.

10. The image sensor according to claim 6, wherein, in a light-receiving direction of the image sensor, sizes of cross sections of the n-potential well layer of each panchromatic pixel gradually increase, sizes of cross sections of the n-potential well layer of each color pixel gradually decrease, and the size of the smallest cross section of the n-potential well layer of each panchromatic pixel is greater than or equal to the size of the largest cross section of the n-potential well layer of each color pixel.

11. The image sensor according to any one of claims 6 to 10, wherein a depth of the photoelectric conversion element of each panchromatic pixel is equal to a depth of the photoelectric conversion element of each color pixel.

12. The image sensor according to any one of claims 6 to 10, wherein each pixel comprises a microlens, a filter, and an isolation layer, and the microlens, the filter, the isolation layer, and the photoelectric conversion element are arranged in sequence in a light-receiving direction of the image sensor.

13. The image sensor according to claim 12, wherein sizes of cross sections of the isolation layer of each pixel are equal in the light-receiving direction of the image sensor, or
when a size of a cross section of the n-potential well layer of each panchromatic pixel is greater than a size of a cross section of the n-potential well layer of each color pixel and when the sizes of the cross sections of the n-potential well layer of each pixel are equal in the light-receiving direction of the image sensor, the sizes of the cross sections of the isolation layer of each panchromatic pixel gradually increase and the sizes of the cross sections of the isolation layer of each color pixel gradually decrease in the light-receiving direction, or
when the sizes of the cross sections of the n-potential well layer of each panchromatic pixel gradually increase and the sizes of the cross sections of the n-potential well layer of each color pixel gradually decrease in the light-receiving direction of the image sensor, the sizes of the cross sections of the isolation layer of each panchromatic pixel gradually increase and the sizes of the cross sections of the isolation layer of each color pixel gradually decrease in the light receiving direction.

14. The image sensor according to claim 5, wherein the panchromatic pixels and the color pixels form a two-dimensional pixel array, and the two-dimensional pixel array comprises minimum repeated units in each of which the panchromatic pixels are arranged in a first diagonal direction and the color pixels are arranged in a second diagonal direction different from the first diagonal direction, and
first exposure time of at least two adjacent panchromatic pixels in the first diagonal direction is controlled by a first exposure signal, and second exposure time of at least two adjacent color pixels in the second diagonal direction is controlled by a second exposure signal.

15. The image sensor according to claim 14, wherein the first exposure time is shorter than the second exposure time.

16. The image sensor according to claim 14, further comprising:
a first exposure control line electrically connected to control terminals of exposure control circuits in at least two adjacent panchromatic pixels in the first diagonal direction; and
a second exposure control line electrically connected to control terminals of exposure control circuits in at least two adjacent color pixels in the second diagonal direction,
wherein the first exposure signal is transmitted via the first exposure control line, and the second exposure signal is transmitted via the second exposure control line.

17. The image sensor according to claim 16, wherein the first exposure control line has a "W" shape and is electrically connected to control terminals of exposure control circuits in the panchromatic pixels in two adjacent rows; and
the second exposure control line has a "W" shape and is electrically connected to control terminals of exposure control circuits in the color pixels in two adjacent rows.

18. The image sensor according to claim 16 or 17, wherein the exposure control circuit is electrically connected to the photoelectric conversion element for transferring an electric potential accumulated at the photoelectric conversion element after being irradiated.

19. The image sensor according to claim 16, wherein the exposure control circuit is a transfer transistor, and the control terminal of the exposure control circuit is a gate of the transfer transistor.

20. The image sensor according to claim 14, wherein each of the minimum repeated units comprises 16 pixels in 4 rows by 4 columns, arranged as:
WAWB
AWBW
WBWC
BWCW,
where W represents the panchromatic pixel,
A represents a first color pixel of the plurality of color pixels,
B represents a second color pixel of the plurality of color pixels, and
C represents a third color pixel of the plurality of color pixels.

21. The image sensor according to claim 14, wherein each of the minimum repeated units comprises 16 pixels in 4 rows by 4 columns, arranged as:
AWBW
WAWB
BWCW
WBWC,
where W represents the panchromatic pixel,
A represents a first color pixel of the plurality of color pixels,
B represents a second color pixel of the plurality of color pixels, and
C represents a third color pixel of the plurality of color pixels.

22. The image sensor according to claim 14, wherein each of the minimum repeated units comprises 36 pixels in 6 rows by 6 columns, arranged as:
WAWBWB
AWAWBW
WAWBWB
BWBWCW
WBWCWC
BWBWCW,
where W represents the panchromatic pixel,
A represents a first color pixel of the plurality of color pixels,
B represents a second color pixel of the plurality of color pixels, and
C represents a third color pixel of the plurality of color pixels.

23. The image sensor according to claim 14, wherein each of the minimum repeated units comprises 36 pixels in 6 rows by 6 columns, arranged as:
AWAWBW
WAWBWB
AWAWBW
WBWCWC
BWBWCW
WBWCWC,
where W represents the panchromatic pixel,
A represents a first color pixel of the plurality of color pixels,
B represents a second color pixel of the plurality of color pixels, and
C represents a third color pixel of the plurality of color pixels.

24. The image sensor according to claim 14, wherein each of the minimum repeated units comprises 64 pixels in 8 rows by 8 columns, arranged as:
WAWAWBWB
AWAWBWBW
WAWAWBWB
AWAWBWBW
WBWBWCWC
BWBWCWCW
WBWBWCWC
BWBWCWCW,
where W represents the panchromatic pixel,
A represents a first color pixel of the plurality of color pixels,
B represents a second color pixel of the plurality of color pixels, and
C represents a third color pixel of the plurality of color pixels.

25. The image sensor according to claim 14, wherein each of the minimum repeated units comprises 64 pixels in 8 rows by 8 columns, arranged as:
AWAWBWBW
WAWAWBWB
AWAWBWBW
WAWAWBWB
BWBWCWCW
WBWBWCWC
BWBWCWCW
WBWBWCWC,
where W represents the panchromatic pixel,
A represents a first color pixel of the plurality of color pixels,
B represents a second color pixel of the plurality of color pixels, and
C represents a third color pixel of the plurality of color pixels.

26. The image sensor according to any one of claims 20 to 25, wherein
the first color pixel A is a red pixel R,
the second color pixel B is a green pixel G, and
the third color pixel C is a blue pixel Bu.

27. The image sensor according to any one of claims 20 to 25, wherein
the first color pixel A is a red pixel R,
the second color pixel B is a yellow pixel Y, and
the third color pixel C is a blue pixel Bu.

28. The image sensor according to any one of claims 20 to 25, wherein
the first color pixel A is a magenta pixel M,
the second color pixel B is a cyan pixel Cy, and
the third color pixel C is a yellow pixel Y.

29. The image sensor according to any one of claims 14 and 20 to 25, wherein a response band of each panchromatic pixel is a visible light band.

30. The image sensor according to any one of claims 14 and 20 to 25, wherein response bands of each panchromatic pixel are a visible light band and a near-infrared band, which match response bands of the photoelectric conversion element in the image sensor.

31. A camera assembly, comprising the image sensor according to any one of claims 1 to 30.

32. The camera assembly according to claim 31, wherein each minimum repeated unit comprises a plurality of subunits, each of the plurality of subunits comprises a plurality of monochromatic pixels and a plurality of panchromatic pixels, and the image sensor is configured to be exposed to obtain an original panchromatic image and an original color image, and wherein the camera assembly further comprises a processing chip configured to:
process the original color image to determine all pixels in each subunit as a large monochromatic pixel corresponding to a single color in the subunit, and output pixel values of the large monochromatic pixels to obtain an intermediate color image;
process the original panchromatic image to obtain an intermediate panchromatic image; and
process the intermediate color image and/or the intermediate panchromatic image to obtain a target image.

33. The camera assembly according to claim 32, wherein all the panchromatic pixels and all the color pixels in the image sensor are exposed simultaneously, and
the image sensor is configured to output pixel values of all the panchromatic pixels to obtain the original panchromatic image, and output pixel values of all the color pixels to obtain the original color image.

34. The camera assembly according to claim 32, wherein all the panchromatic pixels and all the color pixels in the image sensor are exposed in a time division manner, and
the image sensor is configured to output pixel values of all the panchromatic pixels to obtain the original panchromatic image, and output pixel values of all the color pixels to obtain the original color image.

35. The camera assembly according to claim 32, wherein the processing chip is further configured to obtain ambient brightness, and
when the ambient brightness is greater than the brightness threshold, first exposure time is shorter than second exposure time.

36. The camera assembly according to claim 32, wherein the processing chip is further configured to:
merge pixel values of all pixels in each subunit to obtain the pixel value of the large monochromatic pixel; and
form the intermediate color image based on pixel values of a plurality of large monochromatic pixels, the intermediate color image having a first resolution.

37. The camera assembly according to claim 36, wherein the processing chip is further configured to:
perform an interpolation processing on each large monochromatic pixel in the intermediate color image to obtain and output pixel values of two colors other than the single color to obtain a first target image having the first resolution.

38. The camera assembly according to claim 36, wherein the processing chip is further configured to:
process the original panchromatic image to determine all pixels in each subunit as a large panchromatic pixel, and output pixel values of the large panchromatic pixels to obtain an intermediate panchromatic image, the intermediate panchromatic image having the first resolution;
separate color and brightness of the intermediate color image to obtain a color-brightness separated image having the first resolution;
fuse brightness of the intermediate panchromatic image and brightness of the color-brightness separated image to obtain a brightness-corrected color image having the first resolution; and
perform an interpolation processing on each large monochromatic pixel in the brightness-corrected color image to obtain and output pixel values of two colors other than the single color to obtain a second target image having the first resolution.

39. The camera assembly according to claim 38, wherein the processing chip is further configured to:
merge pixel values of all the pixels in each subunit to obtain the pixel value of the large panchromatic pixel; and
form the intermediate panchromatic image based on the pixel values of a plurality of large panchromatic pixels.

40. The camera assembly according to claim 36, wherein the processing chip is further configured to:
interpolate the intermediate color image to obtain an interpolated color image having a second resolution higher than the first resolution, corresponding subunits in the interpolated color image being arranged in a Bayer array; and
perform an interpolation processing on all monochromatic pixels in the interpolated color image to obtain and output pixel values of two colors other than the single color to obtain a third target image having the second resolution.

41. The camera assembly according to claim 36, wherein the processing chip is further configured to:
interpolate the original panchromatic image to obtain pixel values of all pixels in each subunit to obtain an intermediate panchromatic image having a second resolution higher than the first resolution;
interpolate the intermediate color image to obtain an interpolated color image having the second resolution, corresponding subunits in the interpolated color image being arranged in a Bayer array;
separate color and brightness of the interpolated color image to obtain a color-brightness separated image having the second resolution;
fuse brightness of the interpolated panchromatic image and brightness of the color-brightness separated image to obtain a brightness-corrected color image having the second resolution; and
perform an interpolation processing on all monochromatic pixels in the brightness-corrected color image to obtain and output pixel values of two colors other than the single color to obtain a fourth target image having the second resolution.

42. The camera assembly according to any one of claims 37 to 41, wherein the image sensor is applied to the camera assembly, and the camera assembly has different modes corresponding to different target images.

43. The camera assembly according to claim 42, wherein
when the mode is a preview mode, the target image is the first target image or the second target image, or
when the mode is an imaging mode, the target image is the second target image, the third target image, or the fourth target image.

44. The camera assembly according to claim 42, wherein
when the mode is a preview mode plus a low power consumption mode, the target image is the first target image,
when the mode is the preview mode plus a non-low power consumption mode, the target image is the second target image,
when the mode is an imaging mode plus the low power consumption mode, the target image is the second target image or the third target image, or
when the mode is the imaging mode plus the non-low power consumption mode, the target image is the fourth target image.

45. The camera assembly according to any one of claims 37 to 41, wherein the processing chip is further configured to obtain ambient brightness,
when the ambient brightness is greater than a brightness threshold, the target image is the first target image or the third target image; and
when the ambient brightness is smaller than the brightness threshold, the target image is the second target image or the fourth target image.

46. A mobile terminal, comprising:
a housing; and
the image sensor according to any one of claims 1 to 30, the image sensor being mounted in the housing.

47. The camera assembly according to claim 46, wherein each minimum repeated unit comprises a plurality of subunits, each of the plurality of subunits comprises a plurality of monochromatic pixels and a plurality of panchromatic pixels, and the image sensor is configured to be exposed to obtain an original panchromatic image and an original color image, and wherein the mobile terminal further comprises a processor configured to:
process the original color image to determine all pixels in each subunit as a large monochromatic pixel corresponding to a single color in the subunit, and output pixel values of the large monochromatic pixels to obtain an intermediate color image;
process the original panchromatic image to obtain an intermediate panchromatic image; and
process the intermediate color image and/or the intermediate panchromatic image to obtain a target image.

48. The mobile terminal according to claim 47, wherein all the panchromatic pixels and all the color pixels in the image sensor are exposed simultaneously, and
the image sensor is configured to output pixel values of all the panchromatic pixels to obtain the original panchromatic image, and output pixel values of all the color pixels to obtain the original color image.

49. The mobile terminal according to claim 47, wherein all the panchromatic pixels and all the color pixels in the image sensor are exposed in a time division manner, and
the image sensor is configured to output pixel values of all the panchromatic pixels to obtain the original panchromatic image, and output pixel values of all the color pixels to obtain the original color image.

50. The mobile terminal according to claim 47, wherein the processor is further configured to obtain ambient brightness, and
when the ambient brightness is greater than the brightness threshold, first exposure time is shorter than second exposure time.

51. The mobile terminal according to claim 47, wherein the processor is further configured to:
merge pixel values of all pixels in each subunit to obtain the pixel value of the large monochromatic pixel; and
form the intermediate color image based on pixel values of a plurality of large monochromatic pixels, the intermediate color image having a first resolution.

52. The mobile terminal according to claim 51, wherein the processor is further configured to:
perform an interpolation processing on each large monochromatic pixel in the intermediate color image to obtain and output pixel values of two colors other than the single color to obtain a first target image having the first resolution.

53. The mobile terminal according to claim 51, wherein the processor is further configured to:
process the original panchromatic image to determine all pixels in each subunit as a large panchromatic pixel, and output pixel values of the large panchromatic pixels to obtain an intermediate panchromatic image, the intermediate panchromatic image having the first resolution;
separate color and brightness of the intermediate color image to obtain a color-brightness separated image having the first resolution;
fuse brightness of the intermediate panchromatic image and brightness of the color-brightness separated image to obtain a brightness-corrected color image having the first resolution; and
perform an interpolation processing on each large monochromatic pixel in the brightness-corrected color image to obtain and output pixel values of two colors other than the single color to obtain a second target image having the first resolution.

54. The mobile terminal according to claim 53, wherein the processor is further configured to:
merge pixel values of all the pixels in each subunit to obtain the pixel value of the large panchromatic pixel; and
form the intermediate panchromatic image based on the pixel values of a plurality of large panchromatic pixels.

55. The mobile terminal according to claim 51, wherein the processor is further configured to:
interpolate the intermediate color image to obtain an interpolated color image having a second resolution higher than the first resolution, corresponding subunits in the interpolated color image being arranged in a Bayer array; and
perform an interpolation processing on all monochromatic pixels in the interpolated color image to obtain and output pixel values of two colors other than the single color to obtain a third target image having the second resolution.

56. The mobile terminal according to claim 51, wherein the processor is further configured to:
interpolate the original panchromatic image to obtain pixel values of all pixels in each subunit to obtain an intermediate panchromatic image having a second resolution higher than the first resolution;
interpolate the intermediate color image to obtain an interpolated color image having the second resolution, corresponding subunits in the interpolated color image being arranged in a Bayer array;
separate color and brightness of the interpolated color image to obtain a color-brightness separated image having the second resolution;
fuse brightness of the interpolated panchromatic image and brightness of the color-brightness separated image to obtain a brightness-corrected color image having the second resolution; and
perform an interpolation processing on all monochromatic pixels in the brightness-corrected color image to obtain and output pixel values of two colors other than the single color to obtain a fourth target image having the second resolution.

57. The mobile terminal according to any one of claims 52 to 56, wherein the image sensor is applied in the mobile terminal, and the camera assembly has different modes corresponding to different target images.

58. The mobile terminal according to claim 57, wherein
when the mode is a preview mode, the target image is the first target image or the second target image, or
when the mode is an imaging mode, the target image is the second target image, the third target image, or the fourth target image.

59. The mobile terminal according to claim 57, wherein
when the mode is a preview mode plus a low power consumption mode, the target image is the first target image,
when the mode is the preview mode plus a non-low power consumption mode, the target image is the second target image,
when the mode is an imaging mode plus the low power consumption mode, the target image is the second target image or the third target image, or
when the mode is the imaging mode plus the non-low power consumption mode, the target image is the fourth target image.

60. The mobile terminal according to any one of claims 52 to 56, wherein the processing chip is further configured to obtain ambient brightness,
when the ambient brightness is greater than a brightness threshold, the target image is the first target image or the third target image; and
when the ambient brightness is smaller than the brightness threshold, the target image is the second target image or the fourth target image.
